# EUROPEAN PATENT SPECIFICATION

(11) **EP 2 909 027 B1**
(45) Date of publication and mention of the grant of the patent: **09.10.2019**
(21) Application number: 13847531.4
(22) Date of filing: 18.10.2013
(51) Int. Cl.: B32B 5/16, B32B 27/04, B32B 19/02, H01L 23/29, H01L 51/52, C08J 5/18, C08J 7/04

(54) **ENCAPSULATION BARRIER STACK**
VERKAPSELUNGSBARRIERENSTAPEL
EMPILEMENT DE BARRIÈRES D'ENCAPSULATION

(30) Priority: 18.10.2012 US 201261715420 P
(43) Date of publication of application: 26.08.2015
(73) Proprietor: Tera-Barrier Films Pte Ltd, Singapore 117586 (SG)
(72) Inventor: RAMADAS, Senthil Kumar, Singapore 467303 (SG); SHANMUGAVEL, Saravanan, 41050 Klang Selangor (MY)
(74) Representative: Schiweck Weinzierl Koch Patentanwälte Partnerschaft mbB
(86) International application number: PCT/SG2013/000448
(87) International publication number: WO 2014/062135

(56) References cited:
- EP-A1- 1 925 732
- WO-A1-2008/057045
- WO-A1-2008/057045
- WO-A1-2009/126115
- WO-A1-2009/134211
- WO-A1-2010/140980
- WO-A1-2013/062486
- WO-A1-2013/062486

## Description

### FIELD OF THE INVENTION

The present invention relates to the field of barrier stacks, and more particularly to a barrier stack that includes encapsulated nanoparticles in a sealing layer arranged on a substrate. The encapsulation of the particles can be obtained by polymerising a polymerisable compound (a monomeric or a polymeric compound with polymerisable groups) or cross-linking a cross-linkable compound on the surface of the reactive nanoparticles. A sealing layer that includes or consists of the encapsulated nanoparticles is arranged on a substrate. The so obtained encapsulation barrier stack is capable of encapsulating a moisture and/or oxygen sensitive article, for example a food packaging, a medical packaging or an electronic device.

### BACKGROUND OF THE INVENTION

Multi-layer high barrier flexible packaging stacks (films) are extensively used in packaging of various types of food products. These stacks (films) should be of high quality in terms of barrier properties to ensure preservation of aroma and also extend the shelf life of the food and at the same time the films should be manufactured at low cost. Another critical issue in food packaging is that of migration and permeability of oxygen or water vapour. No packaging material such as plastic film is completely impermeable to atmospheric gasses, water vapour or natural substances contained within the food being packaged or even the packaging material itself. In some applications, high barriers to migration or gas diffusion are undesirable, such as in packages for fresh fruits and vegetables whose shelf life is dependent on access to a continual supply of oxygen for sustained cellular respiration. Plastics utilized for carbonated beverage containers, on the other hand, must have high oxygen and carbon dioxide barriers in order to prevent oxidation and de-carbonation of the beverage contents. In other products, migration of carbon dioxide is far less of an issue than that of either oxygen or water vapour. As a result of these complexities, food products require sophisticated and remarkably different packaging functions, and the demands on the packaging industry will only increase as the trend continues to transport food over increasingly longer distances between producers and consumers.

Typical laminates that are used in food packaging are Polyethylene terephthalate/Polyethylene (Poly) based laminates such as PET/Poly, Pet/Foil/Poly, PET/metal or oxide coated PET/Poly, PET/Cast Polypropylen (Cpp), PET/Biaxially Oriented Polypropylene (Bopp), Bopp/Poly, Bopp/Bopp, Bopp/metal or oxide coated Bopp, Pet/Nylon-Poly 5 layer. In this regard, it is noted that metal oxide films produced by high speed manufacturing processes of the art (with a speed of for example, 500m/min to 1000m/min) exhibit a porous microstructure and have numerous defects, meaning that laminates based on such metal oxide films usually require lamination with multiple (polymer) layers to achieve satisfying barrier properties.

In this context, it is also noted that plastic substrate or films are porous in nature and the typical moisture transmission rate through plastic films is in the range of 50g/m²·day to 1g/m²·day at ambient condition and depends upon type of the plastic films. The transmission (permeability) of polymeric/plastic materials to gases is determined by the adsorption rate of gas molecules into the matrix at the atmosphere/polymer boundary and the diffusion rate of adsorbed gas molecules through the matrix. The adsorption rate is generally dependent on the rate of formation of free volume holes in the polymer created by random (Brownian) or thermal motions of the polymer chains, and diffusion is caused by jumps of molecular gas molecules to neighbouring (empty) holes. Thus the permeability of polymer films is dependent on free volume hole sizes, degree of polymer motion, and specific polymer-polymer and polymer-gas interactions, all of which can be affected by intrinsic polymer chemistry as well as external properties such as temperature and pressure.

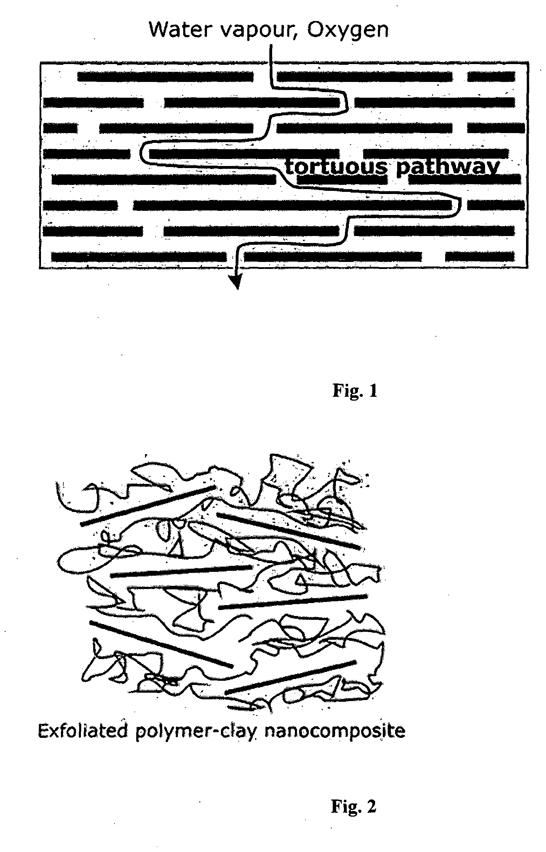

One attempt to increase the barrier properties of a homogenous polymer film is the dispersal of nano-sized fillers into the polymer matrix. See for example, US Patent No. 5,916,685. So doing, increases the barrier properties of a homogeneous polymer film in two specific ways. The first way is by creating a tortuous path for gas diffusion. Because the filler materials are essentially impermeable inorganic crystals, gas molecules must diffuse around them rather than taking a (mean) straight-line path that lies perpendicular to the film surface. The result is a longer mean path for gas diffusion through the film in the presence of fillers, as illustrated in **Fig. 1**. The effect of dispersed nanomaterials on the mean path length for gas diffusion has been modelled theoretically. The simplest model, first proposed by Nielsen (J. Macromol. SCI, (CHEM) A1 (5) 929-942 (1967))assumes that fillers are evenly dispersed throughout the matrix and take the shape of rectangular platelets of uniform size, and supposes that the tortuosity of the path is the only factor influencing the gas diffusion rate. In practice, this model is valid only for small loading percentages (< 10%), as higher loadings result in particle agglomeration, which in turn effectively reduces the mean particle aspect ratio and may affect other properties of the system such as the amount of polymer available to intercalate into the nanoclay galleries and the proportion of "interphase" regions in which the nanoclay surface and any organic modifiers interact directly with the polymeric host material. Improvements on the Nielsen model include adjustments for random positioning of the filler throughout the matrix, as well as filler shape hexagonal or disk, size uniformity, angular orientation with respect to the lateral dimension of the film, degree of agglomeration or stacking, and high nanoclay filler contents. In general all of these models predict that large volume fractions or large particle aspect ratios are required to reduce the gas permeability by an appreciable degree.

Tortuosity is usually the primary mechanism by which nanofillers impact the barrier properties of nanocomposite. The second way that nanoparticulate fillers influence the barrier properties is by causing changes to the polymer matrix itself at the interfacial regions. If the polymer-nanoparticle interactions are favourable, polymer strands located in close proximity to each nanoparticle can be partially immobilized. The result is that gas molecules traveling through these interfacial zones have attenuated hopping rates between free volume holes, or altered density and or size of holes, a fact which has been observed directly via the use of positron annihilation lifetime spectroscopy. In addition, the presence of surfactants or other additives used to efficiently incorporate the filler into the matrix (see also **Fig. 2** showing an illustration of the "tortuous pathway" created by incorporation of exfoliated clay nanoplatelets into a polymer matrix film).

Thus, it would be desirable to have alternative barrier stacks (films) which have high barrier properties, are simple and cost effective to manufacture.

It is therefore an object of the present invention to provide such a barrier stack system that overcomes at least some of the above-discussed drawbacks. This object is solved by the subject matter of the independent claims.

### SUMMARY OF THE INVENTION

In one aspect the invention provides an encapsulation barrier stack, capable of encapsulating a moisture and/or oxygen sensitive article and comprising a film layer (with at least one layer), wherein the film layer comprises:
- one or more nanoparticle sealing layer(s) arranged to be in contact with a surface of the at least one substrate, wherein the substrate is not a barrier layer,
wherein the one or more nanoparticle sealing layer(s) comprise(s) a plurality of encapsulated nanoparticles, the nanoparticles being reactive in that they are capable of interacting with moisture and/or oxygen to retard the permeation of moisture and/or oxygen.

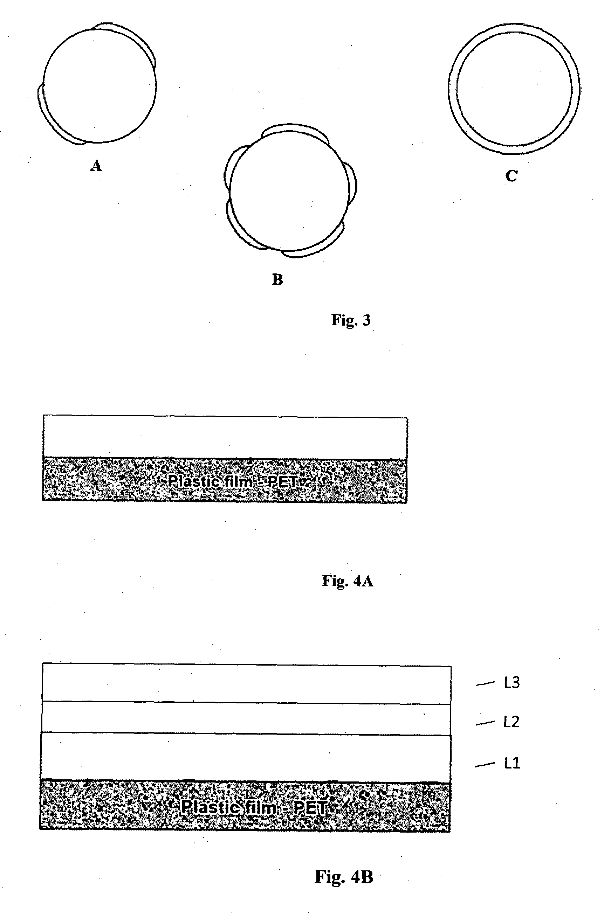

In this regard, it is noted that such a barrier stack shows improved flexibility, gas barrier properties, weatherability, as well as improved optical and mechanical properties and a high reliability of flexible high and is yet a cost effective solution when it comes to manufacturing. An encapsulation barrier stack according to the invention has polymer-encapsulated nanoparticles, in some embodiments also functionalized nanoparticles. In this context, it is noted that the term "encapsulated" does not necessarily mean that the entire surface of the reactive nanoparticle is coated/encapsulated with the cured polymerisable compound. Rather than the surface of the nanoparticle being 100% encapsulated, it is also encompassed in the present invention that only about 70% or more, or 75% or more, or 80 % or more, or 85% or more, or 90% or more or 95% or more of the surface of the reactive nanoparticles are encapsulated or in other words passivated by the polymerisable compound after curing (cf. also **Fig. 3**). The present inventors have surprisingly found that these nanoparticles are capable of sealing or plugging defects in the substrate and that they also enhance gas barrier properties of the substrate. In addition an encapsulated barrier stack according to the invention is a low-cost device that has advantageous multi-functional properties including improved stretchability and excellent mechanical properties such as adhesion and weatherability.

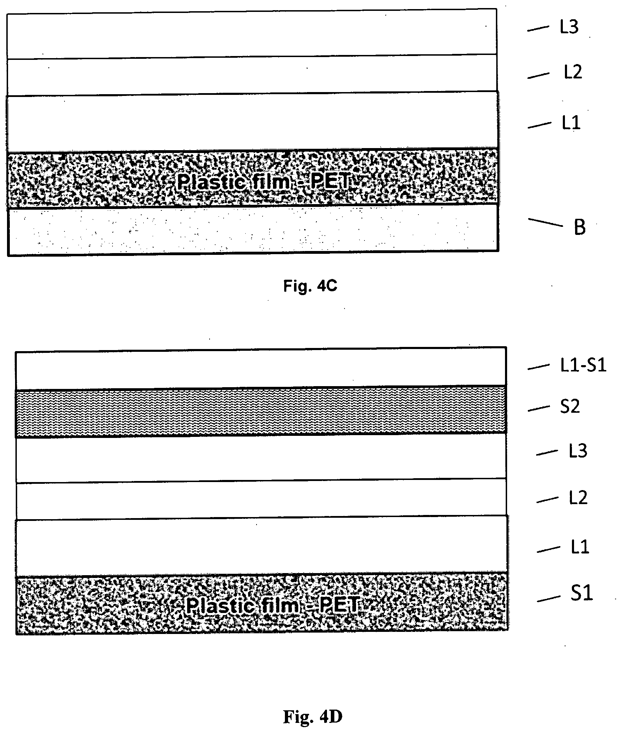

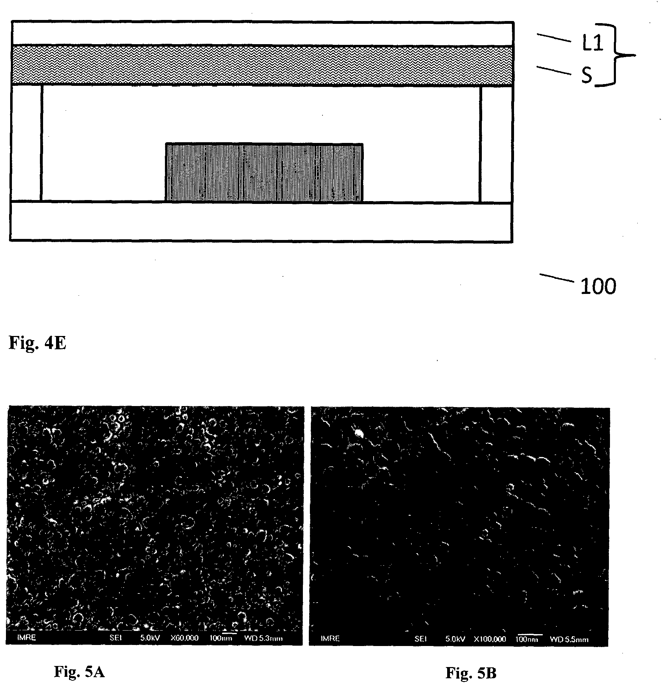

The sealing layer of a barrier stack of the invention may contain functionalized nanoparticles which are either encapsulated or passivated by polymer or organic species. The sealing layer may in some embodiments be a single layer. In some embodiments the encapsulated barrier stack has a single sealing layer. In some embodiments the encapsulated barrier stack includes multiple sealing layers. Examples of embodiments of the general build-up of a barrier stack according to the invention are depicted in **Fig. 4**.

According to a second aspect, the invention provides a packaging material that comprises an encapsulation barrier stack according to the first aspect of the invention. The packaging material can be a food packaging material, a pharmaceutical packaging material or a packaging material for medical materials.

According to a third aspect, the invention provides a method of manufacturing an encapsulation barrier stack according to the first aspect. The method includes
- providing a substrate, and
- forming a film layer comprising forming one or more nanoparticle sealing layer(s), wherein forming the one or more nanoparticle sealing layer(s) comprises
   (i) mixing a polymerisable compound or a cross-linkable compound with a plurality of nanoparticles, the nanoparticles being reactive in that they are capable of interacting with moisture and/or oxygen, thereby forming a sealing mixture, and
   (ii) applying the sealing mixture onto the substrate and polymerising the polymerisable compound or to cross-link the cross-linkable compound to form a polymer under conditions allowing the nanoparticles to be encapsulated by the formed polymer.

In this context, it is noted that conditions that allow the nanoparticles to be encapsulated as for example, conditions in which the polymerisable compound is present in the sealing mixture in such a concentration that the polymerisable compound will interact with the nanoparticles. Such condition may include using a low concentration of the polymerisable compound in the sealing mixture. Such conditions include the conditions described in US provisional application 61/550,764 "Encapsulation Barrier Stack" filed 24 October 2011, the entire contents of which is incorporated by reference in its entirety for all purposes. For example, in such a liquid sealing solution the polymerisable compound may be present in a concentration of about 10 % (w/v) or less of the sealing mixture or of 5 % (w/v) of the sealing mixture or of 3% (w/v) of the sealing mixture or even less.. Expressed differently, such conditions might also be achieved by using 25 wt.-% or less (dry form), or 10 % wt.-% or less of the polymerisable compound of the weight of the reactive nanoparticles (that means a weight ratio of 1:4 or less or a weight ratio of 1:9 of less). The weight ratio of the polymerisable compound (which can be a monomeric compound) to reactive nanoparticles weight can thus be 1: 9 or less. Under such conditions, a sealing solution contains such low concentrations of the polymerisable compound (a monomeric compound, for example) that the polymerisable compound is adsorbed on the reactive nanoparticle, thereby coating the reactive nanoparticles with the polymerisable compound. In order to facilitate conditions that allow the nanoparticles to be encapsulated, the sealing solution may also be sonicated such that polymerisable compound is mixed with the nanoparticles and the freely moving reactive nanoparticles are coated with the polymerisable compound during the sonication treatment. If such a sealing solution is then applied onto a barrier layer and exposed to curing conditions, curing creates a cross-linked (polymerized) compound on the surface of reactive nanoparticles and, possibly, also between different nanoparticles. However, if crosslinking between different nanoparticles occurs during the curing, the sealing layer as described here does not form a polymer matrix as described in US patent US 8,039,739 B1, US patent application US 2005/0249901 A1 or International patent application WO2008/057045 in which the nanoparticles are distributed and embedded in the polymer matrix. Rather, the nanoparticle layer formed in the present invention is substantially (say in typical embodiments to about at least 80%, or 90%, or 95% of the surface of nanoparticle covered by encapsulation material) or entirely by the individually encapsulated nanoparticles. In addition, in the present invention, the sealing layer is formed substantially (say to about at least 80%, or 90%, or 95%) or entirely by the individually encapsulated nanoparticles.

In some embodiments a surfactant is added to the sealing mixture. In some embodiments a surface-modifying compound such as a silane is added to the sealing mixture.

According to a fourth aspect, the invention relates to the use of polymer encapsulated reactive nanoparticles for preparing a sealing layer of a barrier stack according to the first aspect. The nanoparticles are reactive in that they are capable of interacting with moisture and/or oxygen to retard the permeation of moisture and/or oxygen through the defects present in the substrate on which the nanoparticles are deposited.

According to a fifth aspect, the invention relates to the use of a barrier stack according to the first aspect for packaging. The packaging may, for example, be a food packaging, a pharmaceutical packaging or a medical packaging.

In typical embodiments of an encapsulation barrier stack of the invention encapsulated nanoparticles as described and used in US provisional application 61/550,764 "Encapsulation Barrier Stack" filed 24 October 2011 or the corresponding International patent application WO 2013/062486, filed 24 October 2012 may be used. The difference of the encapsulation barrier stack of the present invention to the encapsulation barrier stack of US provisional application 61/550,764 or PCT application WO 2013/062486 is that the encapsulated nanoparticles are deposited in the present invention on a substrate which is not a barrier layer while in US provisional application 61/550,764 "Encapsulation Barrier Stack" filed 24 October 2011, the encapsulated nanoparticles are deposited on a barrier layer to form a sealing layer thereon. This, however does not mean that the encapsulate barrier stack of the present invention is totally devoid of a barrier layer but it only means that encapsulated nanoparticles are not deposited on a barrier layer so that the resulting sealing layer is not in direct contact with the barrier layer. It is, for example, possible that a barrier layer is deposited on a (second) surface of the substrate that is opposing the (first) surface of the substrate on which the on sealing layer of the encapsulated naonoparticles is arranged. Such an exemplary embodiment is shown in **Fig. 4C**.

In this context, the term "barrier layer" is used in its regular meaning in the art relating to encapsulation technology to refer to a barrier layer made from an inorganic material or also organic material that comprises a barrier material with low permeability to water vapour and/or oxygen in the bulk phase and which is used in the art to provide a "barrier" for gaseous materials such as oxygen, water vapour or any other inert or reactive gases such as carbon dioxide (as an example of an additional reactive gas) or helium, nitrogen (as an example of an inert gas) and the like to permeate through a substrate on which the barrier layer is arranged. Thus, the term "barrier layer" and "inorganic barrier layer" are used interchangeably herein. Such a barrier layer (which as said above, is not in contact with a sealing layer deposited on a substrate may be made of a material selected from the group consisting of a metal, a metal oxide, a metal carbide, a metal nitride, a metal oxynitride, an inorganic polymer or an organic polymer and combinations thereof. Examples of such inorganic barrier layers are disclosed in the International Patent Applications WO2008/057045, WO2009/134211 and WO2010/140980. The barrier layer (material) may, for example, be selected from indium tin oxide (ITO), TiAlN, SiO₂, SiC, Si₃N₄, TiO₂, HfO₂, Y₂O₃, Ta₂O₅, and Al₂O₃. Such barrier layers are typically deposited on a substrate (i.e. manufacture) by techniques such as chemical vapour deposition (CVD) or physical vapour deposition (PVD), and other conventional fabrication methods such as roll-to-roll processes. Generally, a barrier layer as defined herein has a water vapour transmission rate of less than 10⁻¹, less than 10⁻² or less than 10⁻³ g/m²/day at 39°C and 90% humidity. Accordingly, a substrate as used herein (for depositing the one or more sealing layers) has a water vapour transmission rate of more than 10⁻¹ g/m²/day at 39°C & 90% humidity, for example 1 g/m²/day at 39°C & 90% or 10 m²/day at 39°C and 90% or 100 m²/day at 39°C & 90% humidity. As mentioned above, is also encompassed in the present invention that the (encapsulated) nanoparticles can provide barrier properties that prevent inert or reactive gases other than water vapour and oxygen, for example, carbon dioxide, nitrogen or helium from permeating through the nanosealing layer (and the base substrate on which the sealing layer is formed).

Chemical Vapour Deposition methods are known to the person skilled in the art and might be classified by operating pressure (e.g. *Atmospheric pressure CVD* (APCVD) - CVD process at atmospheric pressure, *Low-pressure CVD* (LPCVD) - CVD process at sub-atmospheric pressures, *Ultrahigh vacuum CVD* (UHVCVD) - CVD process at very low pressure, typically below 10⁻⁶ Pa), classified by physical characteristics of vapor (e.g. *Aerosol assisted CVD* (AACVD) or *Direct liquid injection CVD* (DLICVD) or plasma methods, for example). Also Physical Vapour Deposition is well known to the person skilled in the art to refer to vacuum deposition and as a general term used to describe any of a variety of methods to deposit thin films by condensation of a vaporized form of the desired film material onto a substrate surfaces by purely physical processes such as high temperature vacuum evaporation with subsequent condensation, or plasma sputter bombardment.

An encapsulated barrier stack according to the invention may have surface functionalized nanoparticles and/or polymer/monomer encapsulated nanoparticles deposited on the substrate. These nanoparticles may serve in defining a single layer or multi-layers such as two, three, four or even more layers. An encapsulated barrier stack according to the invention has multi-functional properties. The layer(s) of functionalized nanoparticles serve in plugging defects of a substrate, increase the tortious path that is available for a fluid (e.g. gas or moisture), block, for example, UV radiation, act as thermal barrier, improve anti-reflection and anti-static properties of the barrier stack. In addition, the nanoparticles may serve in enhancing thermal barrier properties of the barrier stack.

The one or more nanoparticulate sealing layers, e.g. one, two or three sealing layers, may be deposited by a slot die coating process in single pass coating (simultaneous multilayer coating method), in some embodiments using a triple slot die or by sequential coating. The nanoparticulate layer, such as a multi-layer, is capable of planarizing the plastic substrates and conformably covering the defects of a substrate. In addition, the sealing layer(s) may serve in enhancing the barrier, optical and mechanical properties of the substrate films.

The present invention provides a barrier stack in which a sealing layer is, completely or at least substantially devoid of a polymer matrix in which reactive nanoparticles are embedded. Thus, a sealing layer of the invention includes an amount of porous polymer that is lower than in known barrier stacks. Known barrier stacks have a polymer interlayer in which the nanoparticles are distributed in the polymer layer/matrix. The polymer may become porous, thereby leading to a pathway for oxygen and moisture and reducing the life time of the devices that are encapsulated by the barrier stack. Thus, by reducing or eliminating polymer sealing layers used in the art, the present invention provides a further advantage over known encapsulation barrier stack.

"Reactive" nanoparticles as used herein refer to nanoparticles capable of interacting with moisture and/or oxygen, either by way of chemical reaction (e.g. hydrolysis or oxidation), or through physical or physico-chemical interaction (e.g. capillary action, adsorption, hydrophilic attraction, or any other non-covalent interaction between the nanoparticles and water/oxygen). Reactive nanoparticles may comprise or consist of metals which are reactive towards water and/or oxygen, i.e. metals which are above hydrogen in the reactivity series, including metals from Group 2 to 14 (IUPAC) may be used. Some preferred metals include those from Groups 2, 4, 10, 12, 13 and 14. For example, these metals may be selected from Al, Mg, Ba and Ca. Reactive transition metals may also be used, including Ti, Zn, Sn, Ni, and Fe for example.

Other than metals, reactive nanoparticles may also include or consist of certain metal oxides which are capable of interacting with moisture and/or oxygen, such as TiO₂, Al₂O₃, ZrO₂, ZnO, BaO, SrO, CaO and MgO, VO₂, CrO₂, MoO₂, and LiMn₂O₄. In certain embodiments, the metal oxide may comprise a transparent conductive metal oxide selected from the group consisting of cadmium stannate (Cd₂SnO₄), cadmium indate (CdIn₂O₄), zinc stannate (Zn₂SnO₄ and ZnSnO₂), and zinc indium oxide (Zn₂In₂O₅). In some embodiments a reactive nanoparticle may comprise or consist of a metal, a metal oxide, a metal nitride, a metal sulfite, a metal phosphate, a metal carbide and/or a metal oxynitride. Examples of metal nitrides that can be used include, but are not limited to TiN, AlN, ZrN, Zn₃N₂, Ba₃N₂, Sr₃N₂, Ca₃N₂ and Mg₃N₂, VN, CrN or MoN. Examples of metal oxynitrides that can be used include, but are not limited to TiOₓN_{y} such as TiON, AlON, ZrON, Zn₃(N₁₋ₓOₓ)_{2-y}, SrON, VON, CrON, MoON and stoichiometric equivalents thereof. Examples of metal carbides include, but are not limited to, hafnium carbide, tantalum carbide or silicon carbide.

In this conjunction, the person skilled in the art understands that reactivity may depend on the size of the material used (see J. Phys. Chem. Solids 66 (2005) 546-550). For example, Al₂O₃ and TiO₂ are reactive towards moisture in the form of nanoparticles but are unreactive (or reactive only to a very small extent) in the (continuous) bulk phase, such as a microscale or millimetre scale barrier layer which is beyond the nanoscale dimension of several nanometres to several hundred nanometres typically associated with nanoparticles. Accordingly, using Al₂O₃ and TiO₂ as illustrative examples, Al₂O₃ and TiO₂ nanoparticles are considered to be reactive towards moisture, whereas Al₂O₃ and TiO₂ bulk layers are passive barrier layers having low reactivity towards moisture. In general, reactive metal or metal oxide nanoparticles, for example Al₂O₃, TiO₂ or ZnO nanoparticles, may be present in suitable colloidal dispersions for the preservation of reactivity and may be synthesized via any conventional or proprietary method such as the NanoArc® method from Nanophase Technologies Corporation.

Apart from metals and metal oxides, reactive nanoparticles in the sealing layer may also comprise or consist of carbon nanoparticles, such as carbon nanotubes, which are hollow, or nanowires, which are solid. The reactive nanoparticles may also comprise or consist of carbon nanoribbons, nanofibres, graphene nanosheets or graphene nanoflakes and any regular or irregular shaped carbon particles with nanoscale dimensions. For carbon nanotubes, single- walled or multi-walled carbon nanotubes may be used. In a study carried out by the present inventors, it was found that carbon nanotubes (CNTs) can serve as a desiccant. Carbon nanotubes can be wetted by low surface tension liquids via capillary action, particularly liquids whose surface tension does not exceed about 200 Nm⁻¹ (Nature, page 801, Vol. 412, 2001). In principle, this would mean that water molecules can be drawn into open-ended carbon nanotubes by capillary suction. It is suggested that water molecules may form quasi-one-dimensional structures within carbon nanotubes, thereby helping to absorb and retain a small volume of oxygen and water molecules. While the quantity of carbon nanotubes may be maximized for maximum moisture and/or oxygen absorption, the inventors have found that in practice lower amounts are also suitable. For example, carbon nanotubes may be used in low quantities of about 0.01% to 10% by weight of the nanoparticles present. Higher concentrations of carbon nanotubes may also be used, but with a corresponding decrease in the transparency of the encapsulation barrier stack.

As further example, the reactive nanoparticles may also be nanofilaments, for example a metal (e.g. a gold or a silver nanowire), a semiconductor (e.g. a silicon or a gallium nitride nanowire) or a polymeric nanoparticle. A further illustrative example is a nanofilament of a metal compound, such as indium phosphide (InP), molybdenum ditelluride (MoTe₂) or Zinc-doped indium phosphide nanowires, molybdenum ditelluride nanotubes. Further examples of nanofilaments of a metal compound include, but are not limited to nanotubes of MoS₂, WS₂, WSe₂, NbS₂, TaS₂, NiCl₂, SnS₂/SnS, HfS₂, V₂O₅, CdS/CdSe and TiO₂. Examples of metal phosphates include, but are not limited to InP and GaP. In one embodiment of a sealing layer, the nanoparticulate metal compound is made of a metal oxide, such as ZnO₂.

The nanoparticles in the sealing layer may also be obtained using a combination of conventional coating methods for the deposition of a seed layer of a metal compound and a solvent thermal method for growing a nanostructure based on the metal compound seeds. The nanostructures obtained by using those methods can be a nanowire, a single-crystal nanostructure, a double-crystal nanostructure, a polycrystalline nanostructure and an amorphous nanostructure.

The nanoparticle, such as a nanowire in the sealing layer may comprise at least one dimension in the range from about 10 nm to 1 µm, e.g. from about 20 nm to about 1 µm, from about 50 nm to about 600 nm, from about 100 nm to about 1 µm, from about 200 nm to about 1 µm, from about 75 nm to about 500 nm, from about 100 nm to about 500 nm, or from about 150 nm to about 750 nm, while another dimension may be in the range from about 200 nm to about 1 µm. The sealing layer may have a thickness from about 200 nm to about 10 µm. In another embodiment, the thickness may be from about 200 nm to about 5 µm, or from about 200 nm to about 2 µm or from about 200 nm to about 1 µm, or at least 200 nm.

In one embodiment, inert nanoparticles are included in the sealing layer and used in conjunction with reactive nanoparticles. As used herein, "inert nanoparticles" refer to nanoparticles which do not interact at all with moisture and/or oxygen, or which react to a small extent as compared to reactive nanoparticles. Such nanoparticles may be included into the sealing layer to further obstruct the permeation of oxygen and/or moisture through the sealing layer. Examples of inert particles include nanoclays as described in US Patent No. 5,916,685. As explained above, such nanoparticles may also serve to plug defects in the substrate, thereby obstructing the path through which permeation takes place, or at least reducing the defect cross-sectional area, thus rendering permeation pathways by which water vapour or oxygen diffuses through the defect much more tortuous, and thus leading to longer permeation time before the barrier layer is breached and thereby improving barrier properties.

Other suitable materials for inert nanoparticles may also include unreactive metals such as copper, platinum, gold and silver; minerals or clays such as silica, wollastonite, mullite, monmorillonite; rare earth elements, silicate glass, fluorosilicate glass, fluoroborosilicate glass, aluminosilicate glass, calcium silicate glass, calcium aluminum silicate glass, calcium aluminum fluorosilicate glass, titanium carbide, zirconium carbide, zirconium nitride, silicon carbide, or silicon nitride, metal sulfides, and a mixture or combination thereof.

Encapsulation barrier stacks which comprise sealing layers having only inert nanoparticles, such as nanoclay particles, do not belong to the invention.

In addition the barrier stack may have a terminal layer, which defines a surface of the barrier stack in that it is in contact with the ambience. This terminal layer may comprise or consist of an acrylic polymer. The acrylic polymer may encompass metal halogenide particles. An illustrative example of a metal halogenide is a metal fluoride such as LiF and/or MgF₂.

Without wishing to be bound by theory, the inventors believe that strong barrier properties can be achieved also by using a combination of different types of nanoparticles. By studying the absorption/reaction characteristics of different types of nanoparticles, it is possible to select a combination of nanoparticles which complement each other to achieve stronger barrier effects than with a single type of material. For example, different types of reactive nanoparticles may be used in the sealing layer, or a combination of reactive and inert nanoparticles may be used.

In accordance with the above, the sealing layer may include a combination of carbon nanotubes and metal and/or metal oxide nanoparticles. One exemplary embodiment is the combination of TiO₂/Al₂O₃ nanoparticles with carbon nanotubes. Any range of quantitative ratios may be used and optimized accordingly using regular experimentation. In an exemplary embodiment, the quantity of metal oxide nanoparticles present is between 500 to 15000 times (by weight) the quantity of carbon nanotubes. For oxides of metals having low atomic weight, lower ratios can be used. For example, TiO₂ nanoparticles can be used in combination with carbon nanotubes, with the weight ratio of carbon nanotubes to TiO₂ being between about 1:10 to about 1:5, but not limited thereto.

The encapsulation barrier stack of the invention may be used to encapsulate any type of moisture and/or oxygen sensitive article, such as food, pharmaceuticals, medical devices, electronic devices or reactive materials, for example. For encapsulating electroluminescent devices, the quality of light transmitted through the encapsulation barrier stack is particularly important. Thus, when the encapsulation barrier stack is used as a cover substrate over a top-emitting OLED or a quantum dot (opto-electronic) device, or when the encapsulation layer is designed for transparent OLED or see-through displays, the encapsulation barrier stack should not cause the quality of light transmitted by the electroluminescent device to be substantially degraded.

Based on the above requirement, the size of the particles may be chosen in such a way that optical transparency is maintained. In one embodiment, the sealing layer comprises nanoparticles having an average size of less than 1/2, or more preferably less than 1/5, the characteristic wavelength of light produced by the electroluminescent electronic component. In this context, the characteristic wavelength is defined as the wavelength at which the peak intensity of the light spectrum that is produced by the electroluminescent device. For electroluminescent devices emitting visible light, this design requirement translates into nanoparticles having a dimension of less than about 350 nm, or more preferably less than 200 nm.

As the random packing density of nanoparticles in the defects of a substrate is determined by the shape and size distribution of the nanoparticles, it may be advantageous to use nanoparticles of different shapes and sizes to precisely control the sealing of defects of the substrate layer. The nanoparticles may be present in one uniform shape or it may be formed in two or more shapes. Possible shapes that the nanoparticles can assume include spherical shapes, rod shapes, elliptical shapes or any irregular shapes. In the case of rod shaped nanoparticles, they may have a diameter of between about 10 nm to 50 nm, a length of 50 to 400 nm, and an aspect ratio of more than 5, but not limited thereto.

In order to provide efficient interaction between the reactive nanoparticles and the water vapour/oxygen permeating the barrier stack, the nanoparticles occupying the defects may have suitable shapes that would maximize the surface area that can come into contact with the water vapour and oxygen. This means that the nanoparticles may be designed to have a large surface area to volume, or surface area to weight ratio. In one embodiment, the nanoparticles have a surface area to weight ratio of between about 1 m²/g to about 200 m²/g. This requirement can be achieved by using nanoparticles with different shapes, such as two, three, four or more different shapes as described above.

A binder in which the nanoparticles are distributed may optionally be used in the sealing layer. Materials suitable for use as the binder include polymers, such as polymers derivable from monomers having at least one polymerisable group, and which can be readily polymerised. Examples of polymeric materials suitable for this purpose include polyacrylate, polyacrylamide, polyepoxide, parylene, polysiloxanes and polyurethane or any other polymer. For strong adhesion between two successive barrier layers, or to adhere the multilayer film onto a substrate, the polymers with good adhesive quality may be chosen. The sealing layer containing the nanoparticles is typically formed by coating the barrier with a dispersion containing nanoparticles mixed with a monomer solution, e.g. an unsaturated organic compound having at least one polymerisable group. The thickness of the sealing layer comprising binder with distributed nanoparticles therein can be in the range of about 2 nm to about several micrometers. However, it is to be noted here that due to the good barrier properties and mechanical properties that a sealing layer of the invention containing or consisting of encapsulated nanoparticles provides, it is preferred not to use a binder material.

A sealing layer of a multilayer film in an encapsulation barrier stack of the invention is designed to be capable of contacting at least a portion of the surface of a barrier layer. A sealing layer may for example be capable of contacting at least 50 %, at least 60 %, at least 70 %, at least 75 %, at least 80 %, at least 85 %, at least 90 %, at least 92 %, at least 95 %, at least 96 %, at least 97 %, at least 98 %, at least 99 %, at least 99.5 % or 100 % of the surface of the substrate.

In some embodiments, the one or more sealing layer is arranged to be in close proximate contact with the entire surface of the substrate (layer). For example, the at least one sealing layer may be formed over the substrate in such a manner that it conforms to the shape of the substrate or even conforms to the shape of possible defects present on the surface of the substrate, i.e. either occupying or filling up entirely possible pits present in the substrate, or levelling rough protrusions over the surface of the substrate. In this manner, defects giving rise to the permeation of corrosive gases through the encapsulation barrier stack are "plugged", while protrusions which would otherwise give rise to poor interfacial contact between barrier layers are levelled. Any conformal coating or deposition method can be used, e.g. chemical vapour deposition or spin coating. Atomic layer deposition and pulsed laser deposition may also be used to form the sealing layer.

Any suitable substrate that is typically used in applications such as food packaging (see in this context, for example, US 5,916,685 that discloses polymeric film as substrates) may be provided to support the multilayer film. The substrate may be flexible or rigid. The substrate may comprise or be an organic material. The substrate may also or alternatively also comprise or be an inorganic material. The substrate may comprise any suitable material such as polyacetate, polypropylene, polyimide, cellophane, poly(1-trimethylsilyl-1-propyne, poly(4-methyl-2-pentyne), polyimide, polycarbonate, polyethylene, polyethersulfone, epoxy resins, polyethylene terepthalate, polystyrene, polyurethane, polyacrylate, polyacrylamide, polydimethylphenylene oxide, styrenedivinylbenzene copolymers, polyvinylidene fluoride (PVDF), nylon, nitrocellulose, cellulose, glass, indium tin oxide, nano-clays, silicones, polydimethylsiloxanes, biscyclopentadienyl iron, or polyphosphazenes or mixtures or composites of such materials, to name only some illustrative examples. The substrate may also be a laminate used for food packaging such as PET/Poly, Pet/Foil/Poly, PET/metal or oxide coated PET/Poly, PET/Cast Polypropylen (Cpp), PET/Biaxially Oriented Polypropylene (Bopp), Bopp/Poly, Bopp/Bopp, Bopp/metal or oxide coated Bopp, Pet/Nylon-Poly 5 layer (see above). The substrate may be arranged to face the external environment or it may face the encapsulated environment. In food packaging, the substrate may face the internal surface that is in contact with food while the sealing layer of the encapsulation barrier stack or an additional protective layer forms the external surface in contact with atmospheric conditions.

Although it may be possible to form a multilayer film directly on a substrate, a substrate with a rough surface may be undesirable for direct contact with the sealing layer. An interface layer between the film layer and the substrate may be provided to improve the contact between them. In one embodiment, a planarising layer is interposed between the substrate and the at least one sealing layer so that the interface between the substrate and the at least one sealing layer is improved. The planarising layer may include any suitable type of polymeric adhesive material such as epoxy. In one embodiment, the planarising layer comprises polyacrylate (acrylic polymer), as polyacrylate is known for having strong water absorption properties.

In typical embodiments the barrier properties of a single nanoparticle sealing layer, deposited on a substrate such as PET, for example, are 10⁻²g/m²·day to 10^{- 3}g/m²day and multi-layer nanoparticle sealing layer may achieve a water vapour transmission rate of less than 10⁻⁴g/m²·day at 39°C & 90% relative humidity The oxygen barrier properties for a single nanoparticle sealing layer are typically less than 10^{- 3}cc/m²·day·atm at ambient and for multi-layer sealing layer/barrier stack less than 10^{- 4}cc/m²·day·atm. In this context it is noted for purpose of clarity that the barrier properties that the nanoparticle sealing layer(s) provide (e.g. the water vapour transmission) are measured after depositing the layer onto the substrate, meaning that the values given refer to the entire barrier encapsulation stack.

The barrier effect of nanoparticle sealing layers is additive, meaning that the number of pairs of sealing layers coupled together is proportional to the overall barrier property of the multilayer film. Accordingly, for applications requiring high barrier properties, a plurality of nanoparticulate sealing layers may be used. It is also possible that a substrate is arranged, e.g. stacked, on top of a sealing layer in alternating sequence In other words, each sealing layer acts as an interface layer between 2 substrates.

In other embodiments, it is possible that more than one sealing layer for example, 2, 3, 4, or 5 sealing layers are present in the multilayer film. For general purpose applications in which water vapour and oxygen transmission rates are less stringent (e.g. less than 10⁻³ g/m²/day), the multilayer film may include only 1 or 2 nanoparticle sealing layers), whereas for more stringent applications, 3, 4, 5 or more nanoparticle sealing layers may be included in the multilayer film to achieve water vapour permeation rates of less than 10⁻⁴ g/m²/day.

Where more than 2 sealing layers are used, the sealing layers may be formed on opposing sides of the substrate to provide a double-laminated or deposited on to the substrate, or they be formed on the same side of the substrate.

In order to protect the multilayer film from mechanical damage, the multilayer film may be capped or overlaid with a terminal protective layer. The terminal layer may comprise any material having good mechanical strength and is scratch resistant. In one embodiment, the terminal layer comprises an acrylic film having distributed therein LiF and/or MgF₂ particles. In another embodiment, the terminal layer comprises an oxide film such as Al₂O₃ or any inorganic oxide layers.

The encapsulation barrier stack according to the invention may be used for any suitable barrier application, such as in the construction of a casing or housing, or a barrier foil for blister packs, or it may be used as an encapsulating layer over an electronic component. The encapsulation barrier stack may also be laminated or deposited over any existing barrier material, such as packaging materials for food and drinks, to improve their existing barrier properties. In a preferred embodiment, the encapsulation barrier stack is used to form an encapsulation for protecting electroluminescent electronic components comprising moisture and/or oxygen sensitive reactive layers, wherein the electroluminescent component is encapsulated within the encapsulation. Examples of such devices include, but are not limited to, reactive components comprised in Organic Light Emitting Devices (OLEDs), flexible solar cells, thin film batteries, charged-coupled devices (CCDs), or micro-electromechanical sensors (MEMS).

In OLED or quantum dot (opto electronic) device applications, the encapsulation barrier stack may be used to form any part of an encapsulation for isolating the active component of the OLED device. In one embodiment, the encapsulation barrier stack is used to form a base substrate for supporting the reactive layers of the electroluminescent component. In a rim-sealing structure, the encapsulation barrier stack may be used to form a rigid cover that is arranged over the reactive layers of the electroluminescent component. The rigid cover may be attached to the base substrate by means of an adhesive layer, the adhesive layer being arranged at least substantially along the edge of the cover substrate for forming an enclosure around the reactive component. In order to minimize lateral diffusion of oxygen/moisture into the enclosure containing the reactive component, the width of the covering layer or the adhesive layer may be made larger than the thickness of the encapsulation barrier stack. The term "covering layer" used herein refers to any layer that covers the barrier stack, meaning the cover layer is different from the sealing layer. The cover layer can, for example, be a protection layer that provides protection for the barrier stack from mechanical wear and tear (abrasion) or chemical or physical-chemical environmental influences (humidity, sunlight etc.).

In another embodiment, an encapsulation barrier stack as described herein is used to form a flexible encapsulating layer which seals the electroluminescent component against the base substrate. In this case, such an encapsulating layer may wrap around the surface of the electroluminescent component to form a 'proximal encapsulation'. The shape of the encapsulating layer thus conforms to the shape of the reactive component, leaving no gap between the electroluminescent component to be encapsulated and the encapsulating layer.

The present invention is further directed to a method of forming an encapsulation barrier stack according to the invention. The method comprises forming (a film layer comprising) at least one sealing layer on a substrate. As the at least one sealing layer contains reactive nanoparticles, steps involving the preparation and the use of the sealing layer are preferably carried out under vacuum (or an inert atmosphere) to preserve the reactivity of the nanoparticles towards the moisture and/or oxygen. The step of forming the sealing layer may comprise mixing a polymerisable compound with a nanoparticle dispersion to form a sealing mixture, and polymerising the sealing mixture after being applied on the barrier layer under vacuum to form a sealing layer. The nanoparticle dispersion may comprise nanoparticles dispersed in at least one organic solvent. The at least one organic solvent may include any suitable solvent, such as ethers, ketones, aldehydes and glycols, for example.

Nanoparticles may be synthesized by any conventional method known in the art, including vapor phase synthesis (Swihart, Current Opinion in Colloid and Interface Science 8 (2003) 127-133), sol-gel processing, sonochemical processing, cavitation processing, micro-emulsion processing, and high-energy ball milling, for instance. Nanoparticles are also commercially available either as nanoparticle powders or in a ready-made dispersion from Nanophase Technologies Corporation, for example. Proprietary methods may be used to synthesize commercially obtained nanoparticles such as NanoArc® synthesis.

In one embodiment, surface-activation of the nanoparticles is carried out in order to remove contaminants from the surface of the nanoparticles that may interfere with their ability to react with moisture and/or oxygen. Surface activation may comprise treating the nanoparticles with an acid, including a mineral acid such as hydrochloric acid or sulphuric acid. In some embodiments the acid used for said treatment is a dilute acid. Treatment comprises immersing the nanoparticles in the acid for a period of about 1 hour. It is to be noted that nanoparticles which can be easily contaminated such as carbon nanotubes and carbon nanofibres may require surface activation. On the other hand, nanoparticles such as aluminium oxide and titanium oxide may not require surface activation since these nanoparticles have high surface energy.

The polymerisable compound may be any readily polymerisable monomer or pre-polymer. Suitable monomers are preferably readily polymerisable via UV curing or heat curing or any other convenient curing method.

In one embodiment, polyacrylamide is used as polymer for binding the nanoparticles. Acrylic acid monomer powder may be dissolved in polar organic solvents such as 2-methoxyethanol (2MOE) and ethylene glycol (EG) or isopropyl alcohol and ethyl acetate. In order to obtain a uniform distribution of the nanoparticles in the sealing mixture, sonication of the sealing mixture may additionally be carried out. For instance, sonication may be carried out for at least about 30 minutes prior to polymerisation.

A substrate may be a part of the device to be encapsulated, such as a part of a circuit board, or it may be an additional structure that is included as part of the encapsulation, such as a flexible substrate. It is also possible that the substrate is part of the encapsulation barrier stack, comprising a thick barrier layer on which further sealing layers arid barrier layers are subsequently deposited.

Once the substrate has been provided, it can be coated with the sealing solution. The sealing solution may be formed on the barrier layer via any wet process method such as spin coating, screen printing, WebFlight method, tip coating, CVD methods or any other conventional coating methods. Metal oxide and metal nano-particles, as well as carbon nanotubes, can be co-deposited through the wet-coating process or co-evaporated along with monomer or dimers of parylene based polymer films. Any type of parylene dimers including parylene C or D or any other grades can be evaporated along with nano particles.

If multiple sealing layers are to be formed, a substrate can be repetitively coated with the sealing mixture (see also below). In order to establish an multilayer film structure comprising one or more successive sealing layers, the substrate may be successively coated with the sealing solution over several times until the intended number of layers is formed. Each time the sealing solution is applied, it may be cured, for example UV cured prior to the formation of the next sealing layer over it. In this context, it is noted that a substrate can be coated with two or more functional nanoparticular sealing layers. Therefore, a barrier stack of the invention may not a substrate coated with a repeated order of one nanoparticle sealing layer. Rather, a barrier stack might consist of only one substrate on which one, two, three, four or even more functional sealing layers are deposited. Alternatively, if the barrier stack comprises more than one substrate, each substrate might be coated with one or more sealing layers. For example, one substrate might have only one sealing layer coated thereon, whereas a second or third substrate of the barrier stack might have two or more sealing layers arranged on the respective substrate.

After the at least one nanoparticle sealing layer has been formed, optional steps may be taken to complete the construction of the encapsulation barrier stack, such as the formation of a coating such as glass cover, ITO lines or ITO coating. For example, Passive Matrix displays may require ITO lines to be formed on the encapsulation barrier stack. After the cover has been formed, the exposed surface of the cover may be further protected with a protective coating via deposition of a capping layer (MgF/LiF coating).

These aspects of the invention will be more fully understood in view of the following description, drawings and non-limiting examples.

### BRIEF DESCRIPTION OF THE DRAWINGS

The invention will be better understood with reference to the detailed description when considered in conjunction with the non-limiting examples and the accompanying drawings.
**Figure 1** depicts the tortuous pathway for the gas diffusion (oxygen, carbon dioxide but also water vapor in a known arrangement of a polymer film (polymer matrix) filled with a nano clay. The tortuous path, i.e. the permeation path for fluid or the time taken to diffuse through the barrier film depends on the number of layers and the amount of nanoclay particles. If a higher number of layers is used, the path is longer and therefore, higher barrier properties can be achieved.
**Figure 2** shows an illustration of the "tortuous pathway" created in known polymer foil by incorporation of exfoliated clay nanoplatelets into a polymer matrix.
**Figure 3** shows an illustration of polymer encapsulated nanoparticles and with polymer passivated particles as used in the invention, with Figures 3A and 3B showing a partially encapsulated (i.e. a passivated) nanoparticle and Figure 3C showing a completely encapsulated nanoparticle.
**Figure 4A** depicts an embodiment of a barrier stack according to the invention.
**Figure 4B** depicts a further embodiment of a barrier stack according to the invention.
**Figure 4C** depicts yet another embodiment of a barrier stack according to the invention, in which a barrier layer is present in addition to the one or more nanoparticle sealing layers that are deposited onto a substrate (such as a plastic material).
**Figure 4D** depicts yet another embodiment of a barrier stack of the invention in which two substrate are present, each substrate having at least one nanoparticle sealing layer.
**Figure 4E** depicts yet another embodiment of a barrier stack of the invention in which a barrier stack is used for encapsulation of an electronic device.
**Figure 5A** shows polymer encapsulated aluminum oxide nanoparticle (NanoDur™ X1130PMA) with a size of 20 to 30 nm formed on a polyethylene terephthalate (PET) substrate (width of the substrate 300mm, length of the substrate 300 m) by slot-die Roll-to-Roll coating).
**Figure 5B** shows polymer encapsulated aluminum oxide nanoparticles with a size of 40 to 80nm with a transparency of 95% and the thickness of the nanoparticle sealing layer in the range of 350nm to 400nm.
**Figure 6A** shows a transmission electron microscopy (TEM) image of the aluminum oxide (NanoDur™ X1130DPMA) nanoparticles distributed in polymer solution prior to encapsulation.
**Figure 6B** is a scanning electron microscope (SEM) image showing the cross section of (the sealing layer consisting of) polymer encapsulated aluminum oxide nanoparticles deposited onto the PET substrate.
**Figure 6C** shows a SEM image of a sealing layer of encapsulated aluminum oxide nanoparticles deposited onto a PET substrate in which scratches are made in the sealing layer by metal tweezers.
**Figure 6D** shows a cross-section of the scratched nanoparticle sealing layer of Figure 6C.
**Figure 7** shows the results of tensile stress load versus axial strain curve for samples of a PET substrate with a nanoparticle sealing layer formed thereon.

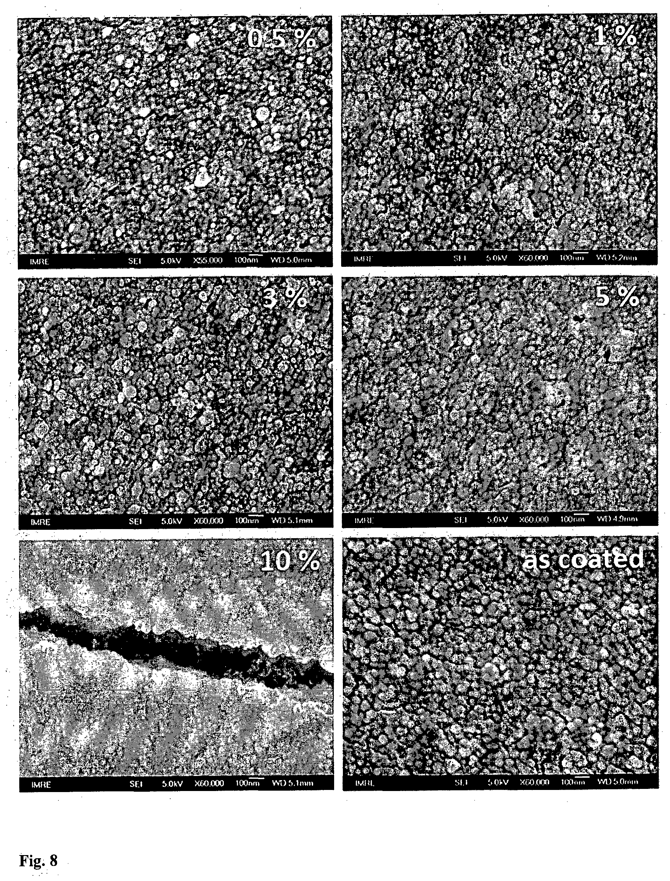

**Figure 8** shows an SEM picture depicting the surface topography of a polymer encapsulated nanoparticle sealing layer on a PET substrate before and after subjecting the barrier stack to axial strains up to 0.5 (upper row, picture on the left side), 1.0, (upper row, picture on the right side) 3.0 (middle row, picture of the left side), 5.0 (middle row, picture on the right side) and 10 % (lower row, picture of the left side). The surface topology of a polymer encapsulated nanoparticle sealing layer that is subjected to axial strain is also shown in Fig. 8 (lowest row, right hand SEM picture).
**Figure 9** shows the drop in optical transparency for the samples shown in Fig. 8 exposed to 0.5, 1.0, 3.0, 5.0 and 10 % axial strain. The curves for 0.5 % (highest percentage of transparency) and for 10 % strain (lowest percentage of transparency) are highlighted with a continuous line in Fig. 9.
**Figure 10** shows a photograph of the X-cross cut tape test (ASTM D 3359) for a encapsulated nanoparticle sealing layer after subjecting the sample to 10% axial strain. Fig. 10 shows no delamination of the nanoparticle sealing layer for the sample having micro cracks after subjecting to 10 % axial strain.
**Figure 11** depicts SEM microscopic images showing the cracks formed on PET for the PET substrate coated with the encapsulated nanoparticle sealing layer subjected to 10 % axial strain.

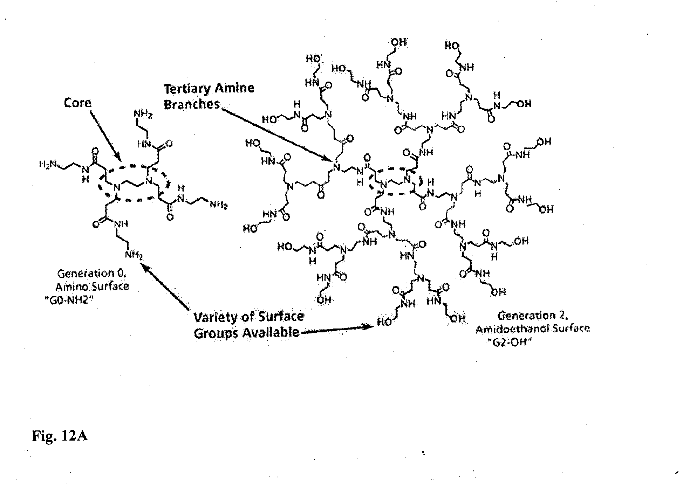

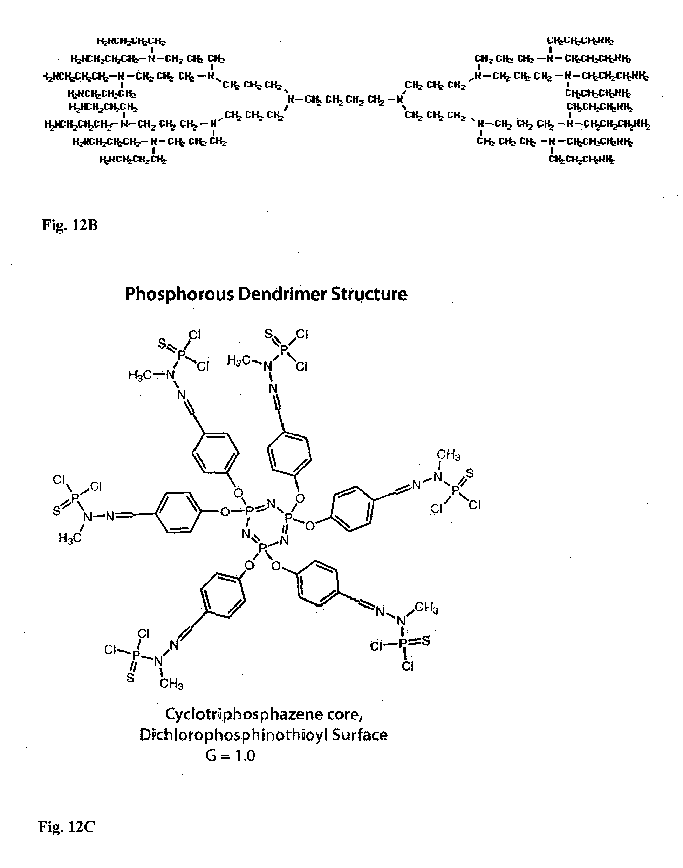

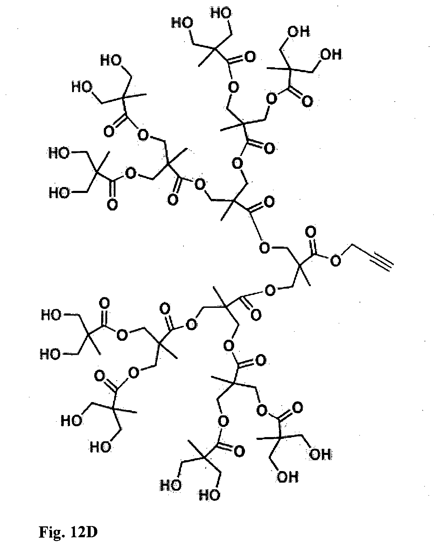

**Figure 12** shows illustrative examples of dendrimers that can be used in the present invention, with **Figure 12A** showing a polyamidoamine (PAMAM) dendrimer that consists of an alkyl-diamine core and tertiary amine branches and that has a variety of surface groups available, for example, for crosslinking, with **Figure 12B** showing a Polypropylenimine hexadecaamine Dendrimer (PEI), Generation 3.0, (linear Formula [-CH₂CH₂N[(CH₂)₃N[(CH₂)₃N[(CH2)₃NH₂]₂]₂]₂]₂, aminopropyl surface groups, 1,4-diaminobutane core (4-carbon core)) and **Figure 12C** showing a phosphorous-based dendrimer such as a cyclotriphosphazene dendrimers based on hexachlorocyclotriphosphazene and **Figure 12D** showing a Polyester-16-hydroxyl-1-acetylene bis-MPA dendron, generation 4.

### DETAILED DESCRIPTION OF THE INVENTION

**FIG. 4A** shows one embodiment of an encapsulation barrier stack according to the invention, which is arranged on a plastic substrate. The encapsulation barrier stack comprises a film with at least one nanoparticle sealing layer. In addition, as shown in **Fig.4B** and **Fig.4C** a barrier stack can also comprise a multilayer film that comprises two nanoparticles sealing layers such as the layers L1, L2 and L3 in the embodiments of **Fig.4B** and **Fig.4C**. This (multilayer) film may, for example, include one, two, three, four, five, six, seven, eight nine or ten sealing layers. In the embodiment depicted in **Fig. 4B** three nanoparticle sealing layers are present. It is also in the scope of the invention that in case of a barrier stack with more than one sealing layers, only the sealing layer that directly contacts the substrate comprises or consists of polymer encapsulated nanoparticles of the invention and that other layers can be a sealing layer of the prior art, for example, a sealing layer as described in International patent application WO2008/057045 in which reactive nanoparticles are distributed in a polymer matrix. In the embodiment depicted in **Fig. 4C** one barrier layer B (made from an inorganic material such as metal oxide, see above) is also present. This barrier layer does not contact the one or more nanoparticle sealing layer L1, L2 or L3 but is arranged to be in contact with the substrate. It is however also within the scope of the present application, that the barrier layer B is also covered by a sealing layer as described in International patent application WO2008/057045, for example, in which nanoparticles are distributed and embedded in a matrix. It is also within the scope of the invention that the barrier layer is covered by a sealing layer as described in US provisional application 61/550,764. In the embodiment depicted in **Fig. 4D** two substrates S1 and S2 are present. Three sealing layers L1, L2 and L3 are arranged on substrate S1, while the second substrate S2 is arranged on sealing layer L3. A single sealing layer L1-S1 is deposited on the substrate S2. **Fig. 4E** shows a further embodiment of the invention. In this embodiment an electronic device 100 such as an OLED is provided in which the electronic device is arranged on a base substrate, and the encapsulation barrier stack of the invention comprising the substrate S and the sealing layer L1 (that comprises of consists of encapsulated nanoparticles forms an encapsulation layer over the electronic device to seal the electronic device from the environment.

The nanoparticle sealing layer(s) comprise(s) reactive nanoparticles capable of interacting with water vapour and/or oxygen, thereby retarding the permeation of oxygen/moisture through the encapsulation barrier stack. In accordance with the present invention, defects present in a substrate are at least partially covered up, or in some embodiments, entirely filled up by the nanoparticles of the sealing layer. In one embodiment, the nanoparticles are polymer encapsulated. Examples of suitable polymers include, but are not limited to, polypropylene, polyisoprene, polystyrene, polyvinyl chloride, polyisobutylene, polyethylene terephthalate (PET), polyacrylates (e.g. polymethyl-methacrylate (PMMA)), ethylene-vinyl acetate (EVA) copolymers, phenol formaldehyde resins, epoxy resins, poly(N-propargylamides), poly(O-propargylesters), and polysiloxanes.

The monomer or the pre-polymer that is used for the encapsulation of the reactive nanoparticles (and that is typically included in a non-aqueous based discontinuous phase solution for the preparation of the sealing layer) may be selected from any suitable hydrophobic material. Illustrative examples of hydrophobic monomers include, but are not limited to, styrenes (e.g., styrene, methylstyrene, vinylstyrene, dimethylstyrene, chlorostryene, dichlorostyrene, tert-butylstyrene, bromostyrene, and p-chloromethylstyrene), monofunctional acrylic esters (e.g., methyl acrylate, ethyl acrylate, isopropyl acrylate, n-butyl acrylate, butoxyethyl acrylate, isobutyl acrylate, n-amyl acrylate, isoamyl acrylate, n-hexyl acrylate, octyl acrylate, decyl acrylate, dodecyl acrylate, octadecyl acrylate, benzyl acrylate, phenyl acrylate, phenoxyethyl acrylate, cyclohexyl acrylate, dicyclopentanyl acrylate, dicyclopentenyl acrylate, dicyclopentenyloxyethyl acrylate, tetrahydrofurfuryl acrylate, isobornyl acrylate, isoamyl acrylate, lauryl acrylate, stearyl acrylate, benhenyl acrylate, ethoxydiethylene glycol acrylate, methoxytriethylene glycol acrylate, methoxydipropylene glycol acrylate, phenoxypolyethylene glycol acrylate, nonylphenol EO adduct acrylate, isooctyl acrylate, isomyristyl acrylate, isostearyl acrylate, 2-ethylhexyl diglycol acrylate, and oxtoxypolyethylene glycol polypropylene glycol monoacrylate), monofunctional methacrylic esters (e.g., methyl methacrylate, ethyl methacrylate, isopropyl methacrylate, n-butyl methacrylate, i-butyl methacrylate, tert-butyl methacrylate, n-amyl methacrylate, isoamyl methacrylate, n-hexyl methacrylate, 2-ethylhexyl methacrylate, lauryl methacrylate, tridecyl methacrylate, stearyl methacrylate, isodecyl methacrylate, octyl methacrylate, decyl methacrylate, dodecyl methacrylate, octadecyl methacrylate, methoxydiethylene glycol methacrylate, polypropylene glycol monomethacrylate, benzyl methacrylate, phenyl methacrylate, phenoxyethyl methacrylate, cyclohexyl methacrylate, tetrahydrofurfuryl methacrylate, tert-butylcyclohexyl methacrylate, behenyl methacrylate, dicyclopentanyl methacrylate, dicyclopentenyloxyethyl methacrylate, and polypropylene glycol monomethacrylate), allyl compounds (e.g., allylbenzene, allyl-3-cyclohexane propionate, 1-allyl-3,4-dimethoxybenzene, allyl phenoxyacetate, allyl phenylacetate, allylcyclohexane, and allyl polyvalent carboxylate), difunctional monomers such as 1,6-hexanediol diacrylate, unsaturated esters of fumaric acid, maleic acid, itaconic acid, etc., and radical polymerizable group-containing monomers (e.g., N-substitued maleimide and cyclic olefins).

In one embodiment, the polymer-encapsulated nanoparticles may be formed in a non-water-based solution (sealing mixture). In this embodiment, the monomers may be selected from acid containing radical polymerizable monomers.

In another embodiment, the polymer-encapsulated nanoparticles may be formed in the sealing mixture of an acid containing radical polymerizable monomers. In this embodiment, the monomer may be selected from acrylic acid, methacrylic acid, acrylamides, methacrylamides, hydroxyethyl-methacrylates, ethylene-oxide-base methacrylates, and combinations thereof.

In another embodiment, the polymer-encapsulated nanoparticle may be formed in a sealing mixture wherein pre-polymers are used. Such pre-polymers might be selected from an acrylic oligomer having a molecular weight less than about 1000 Da and a viscosity less than about 300 cPoise.

In another embodiment, the nanoparticles are dendrimer or dendron encapsulated. As used herein, the terms "dendrimer encapsulated nanoparticle" and "DENs" refer generally to a nanostructure where one dendrimer molecule entraps one or more nanoparticles. Dendrimer encapsulated nanoparticle as used herein refers to nanoparticle of metal, metal oxide, metal halide as disclosed herein which are either encapsulated by the dendrimeric molecule or surrounded by dendrimer or the nanoparticle is a dendrimer core after attachment of dendrons on its surface.

"Dendrimer" or "dendritic structure" means a macromolecule having a branched structure which can be obtained by polymerization (or co-polymerization) of organic monomer units having a functionality greater than 2. The chemical functions present at the ends of the branches of such a structure are referred to by the expression "terminal functions". By definition, the number of terminal functions on a dendritic polymer is greater than 2. Dendrimers are macromolecules composed of monomers which combine with each other in accordance with an arborescent process. Dendrimers, also called "cascade molecules", are highly branched functional polymers of defined structure. These macromolecules are in fact polymers since they are based on the association of repeating units. However, dendrimers differ fundamentally from conventional polymers in as much as they have their own properties owing to their arborescent construction. The molecular weight and the architecture of dendrimers can be precisely controlled. Dendrimers are constructed step by step by the iteration of a reaction sequence allowing the multiplication of each repeating unit and terminal functions. Each reaction sequence forms a so-called "new generation". The arborescent construction is effected by repeating a reaction sequence, which enables a new generation and an increasing number of identical branches and therefore of terminal functions to be obtained at the end of each reaction cycle. After a few generations, the dendrimer generally assumes a globular form which is highly branched and multi-functionalized owing to the large number of "terminal functions" present at the periphery.

In the context of the present description, "modified dendritic structure" means structures in which all or some of the functions, especially terminal functions, are bonded, in a covalent or non-covalent manner, by ionic or Van der Waals interactions, to molecules or macromolecules, which may be hydrophilic or hydrophobic. These modified dendritic structures therefore comprise a "core" formed from the initial dendrimer or hyper-branched polymer and a "cortex" formed by the hydrophilic or hydrophobic molecules, including, especially, fluorinated molecules.

Preferably, the dendrimer structures according to the invention are dendrimers or hyper-branched polymers comprising secondary amine (--NH--) or primary amine (-NH.₂) functions, hydroxyl functions (--OH), carboxylic acid functions (--COOH), halogen functions (Hal), such as CI, Br or I, thiol functions (SH), more preferably amine or hydroxyl functions.

For these amine or hydroxyl functions may advantageously be coupled to molecules comprising functions of the carbonyl (CO) type, such as (--COOH); (--COHal); or ester, for example (--COOAlk) in order to lead to the production of modified dendrimers.

The hydrophilic or hydrophobic molecules that can be used according to the invention also comprise at least one function capable of reacting with at least one of the functions of the dendritic structure, especially with the terminal functions, which are generally readily accessible. For example, the hydrophilic or hydrophobic molecules can react with either a nanoparticle as used here or with metal cations as explained further below.

Dendrimers are known in the art. For example dendrimers according to the invention may be selected from poly(amidoamines) (PAMAM), polyethylene imines (PEI), poly(propyleneimines) (PPI), andpolypropyleneimine dotriacontaamine dendrimers (DAB) and Frechet dendrimers. Those dendrimer molecules are available in different sizes depending on the generation of the dendrimer (e.g. generation-1 to generation-8 or even 10). Examples of dendrimers or hyperbranched polymers are especially poly(amidoamines) (PAMAM), polyethylene imines (PEI), poly(propyleneimines) (PPI), and polypropyleneimine dotriacontaamine dendrimers (DAB), which are commercially available, for example, from Sigma Aldrich. Other examples of hyperbranched polymers are especially the polyphenylenes described by Y. H. Kim and O. W. Webster, the polyamides or the polyesters having a dendritic structure which are, for example, described in the International patent applications WO 92/08749 or WO 97/26294, the polyglycerols or also the polymers described in the International patent applications WO 93/09162, WO 95/06080 or WO95/06081. Known dendrimers are also illustrated in **Fig. 12**.

As mentioned dendrimers may have different "terminal groups", terminal group are functional groups present on the outer shell of the dendrimer. They are also known as "surface groups". "Surface group" is for example the term used by Sigma Aldrich to identify the terminal group of a dendrimer. The dendrimer can have various surface groups such as Amidoethanol Surface Groups, Amidoethylethanolamine Surface Groups - Amino Surface Groups (such Dendrimer-(NHCH₂CH₂)_{Z}) (Z is the average number of surface groups NHCH₂CH₂), Mixed (bi-functional) Surface Groups, Sodium Carboxylate Surface Groups, Succinamic Acid Surface Groups, Trimethoxysilyl Surface Groups, Tris(hydroxymethyl)amidomethane Surface Groups, 3-Carbomethoxypyrrolidinone Surface Groups. Additional surface groups may be PEG molecules having different length, or other crosslinker compounds. The surface group may allow the formation of crosslink between dendrimer encapsulated nanoparticles, additionally they confer different properties to the dendrimer. For example, an amido-ethanol surface group is a neutral alcohol surface group. PAMAM dendrimers, with surfaces fully derivatized with externally presented amidoethanol groups, have higher solubility in less polar organic solvents. The neutral alcohol surface groups render e.g. PAMAM dendrimer having amidoethanol surface group useful in applications where more neutral pH conditions are necessary. To mention another example, the "amino surface group" consists of polar, highly reactive primary amine surface groups. The surfaces of the amino-functional PAMAM dendrimers (i.e. with amino surface groups) are cationic and can be derivatized, either through ionic interactions with negatively charged molecules, or using many well-known reagents for covalent functionalization of primary amines. The sodium carboxylate is an anionic surface group. PAMAM dendrimers with sodium carboxylate surfaces exhibit higher solubility in polar and aqueous solvents. Dendrimer functionalized with different functional groups are commercially available. For example Sigma Aldrich provides a wide variety of PAMAM dendrimers having different core type and/or surface group or having different "generation".

The number of surface groups present in the outer shell may vary for example in dependence of the "generation" of the dendrimer. Typically, the number of surface group is higher for higher generation.

As an illustrative example: Polyamidoamine (PAMAM) dendrimers are the most common class of dendrimers suitable for many material science and biotechnological applications. PAMAM dendrimers consist of an alkyl-diamine core and tertiary amine branches. They are available in generations G 0 - 10 with 5 different core types and 10 functional surface groups. Typically PAMAM dendrimer core types are Ethylendiamine (2 carbon core), 1,4 dibutane amine (4 carbon core), 1,6 diaminohexane (6-carbon core), 1,12 diaminodecane (12-carbone core) and cystamine core (cleavable core). As already mentioned PAMAM dendrimers exist with different surface groups. PAMAM dendrimer having surface group selected from Amidoethanol Surface Groups, Amidoethylethanolamine Surface Groups -Amino Surface Groups (such Dendrimer-(NHCH₂CH₂)_{z}), Mixed (bi-functional) Surface Groups, Sodium Carboxylate Surface Groups, Succinamic Acid Surface Groups, Trimethoxysilyl Surface Groups, Tris(hydroxymethyl)amidomethane Surface Groups 3-Carbomethoxypyrrolidinone Surface Groups are commercially available (Sigma Aldrich).

Other commercially available dendrimers which may be used for preparing the dendrimer encapsulated nanoparticle of the invention are: "DAB-Am-4, Polypropylenimine tetramine dendrimer, generation 1", Hyperbranched bis-MPA polyester-16-hydroxyl, generation 2 (having hydroxyl surface group), Hyperbranched bis-MPA polyester-64-hydroxyl, generation 4 (having hydroxyl surface group-average number 64), DAB-Am-32, Polypropylenimine dotriacontaamine Dendrimer, Generation 4.0, Cyclotriphosphazene-PMMH-12 dendrimer, generation 1.5 (with aldehyde surface group), Cyclotriphosphazene-PMMH-6 dendrimer, generation 1.0 (with dichlorophosphinothioyl surface groups).

"Dendrons" may be defined as are monodisperse wedge-shaped dendrimer sections with multiple terminal groups and a single reactive function at the focal point. They also have surface groups as disclosed above for the dendrimers. They are commercially available e.g., by Sigma Aldrich. As illustrative examples of commercially available dendrons: Polyester-8-hydroxyl-1-acetylene bis-MPA dendron, generation 3; Polyester-16-hydroxyl-1-acetylene bis-MPA dendron, generation 4; Polyester-32-hydroxyl-1-carboxyl bis-MPA dendron, generation 5; Polyester-8-hydroxyl-1-carboxyl bis-MPA dendron, generation 3; Polyester-16-hydroxyl-1-carboxyl bis-MPA dendron, generation 4; Poly(ethylene glycol), 16 hydroxyl dendron, generation 3; Poly(ethylene glycol), 4 acetylene dendron, generation 1; Polyester bis-MPA dendron, 16 hydroxyl, 1 allyl; Polyester bis-MPA dendron, 32 hydroxyl, 1 thiol; Polyester bis-MPA dendron, 2 hydroxyl, 1 azide; Polyester bis-MPA dendron, 2 hydroxyl, 1 acetylene may be mentioned. Several other dendrons are commercially available. The dendrons are characterized by having a reactive focal point that allows the binding of the dendron to the surface of the nanoparticle (conveniently functionalized). Amine group, thiol, azide, allyl, acetylene, hydroxyl, carboxylic group are suitable and known groups for the focal point of dendrons.

It is further noted that "dendrimer" are typically considered polymeric macromolecules composed of multiple perfectly-branched monomers radially emanating from a central core, while hyper-branched polymers are polydisperse dendritic macromolecules that possess dendrimer-like properties but are prepared in a single synthetic polymerization step. They are imperfectly branched and have an average (rather than precise) number of terminal functional groups. For the purpose of the present invention hyper-branched polymers fall under the term "dendrimer".

In some embodiments the one or more sealing layer(s) at least essentially consist(s) of, for example, polymer or dendrimer encapsulated reactive nanoparticles. The term "at least essentially consisting of" means that the respective layer is generally free of other matter, as judged by standard analytical techniques. The layer may contain minor amounts of other matter, but it may also be entirely free of other matter, at least as judged by known analytical techniques. Thus, the one or more sealing layer(s) may consist(s) only of the polymer encapsulated reactive nanoparticles. A portion of the plurality of polymer or dendrimer encapsulated nanoparticles or all polymer or dendrimer encapsulated nanoparticles may have an aliphatic, alicyclic, aromatic or arylaliphatic compound immobilized thereon. The aliphatic, alicyclic, aromatic or arylaliphatic compounds have a polar group. The polar group may, for example, be a hydroxyl group, a carboxyl group, a carbonyl group, an amino group, an amido group, a thio group, a seleno group, and a telluro group.

The term "aliphatic" means, unless otherwise stated, a straight or branched hydrocarbon chain, which may be saturated or mono- or poly-unsaturated and include heteroatoms (see below). An unsaturated aliphatic group contains one or more double and/or triple bonds (alkenyl or alkinyl moieties). The branches of the hydrocarbon chain may include linear chains as well as non-aromatic cyclic elements. The hydrocarbon chain, which may, unless otherwise stated, be of any length, and contain any number of branches. Typically, the hydrocarbon (main) chain includes 1 to 5, to 10, to 15 or to 20 carbon atoms. Examples of alkenyl radicals are straight-chain or branched hydrocarbon radicals which contain one or more double bonds. Alkenyl radicals normally contain about two to about twenty carbon atoms and one or more, for instance two, double bonds, such as about two to about ten carbon atoms, and one double bond. Alkynyl radicals normally contain about two to about twenty carbon atoms and one or more, for example two, triple bonds, such as two to ten carbon atoms, and one triple bond. Examples of alkynyl radicals are straight-chain or branched hydrocarbon radicals which contain one or more triple bonds. Examples of alkyl groups are methyl, ethyl, propyl, butyl, pentyl, hexyl, heptyl, octyl, nonyl, decyl, the n isomers of these radicals, isopropyl, isobutyl, isopentyl, sec-butyl, tert-butyl, neopentyl, 3,3-dimethylbutyl. Both the main chain as well as the branches may furthermore contain heteroatoms as for instance N, O, S, Se or Si or carbon atoms may be replaced by these heteroatoms.

The term "alicyclic" means, unless otherwise stated, a non-aromatic cyclic moiety (e.g. hydrocarbon moiety), which may be saturated or mono-or poly-unsaturated. The cyclic hydrocarbon moiety may also include fused cyclic ring systems such as decalin and may also be substituted with non-aromatic cyclic as well as chain elements. The main chain of the cyclic hydrocarbon moiety may, unless otherwise stated, be of any length and contain any number of non-aromatic cyclic and chain elements. Typically, the hydrocarbon (main) chain includes 3, 4, 5, 6, 7 or 8 main chain atoms in one cycle. Examples of such moieties include, but are not limited to, cyclopentyl, cyclohexyl, cycloheptyl, or cyclooctyl. Both the cyclic hydrocarbon moiety and, if present, any cyclic and chain substituents may furthermore contain heteroatoms, as for instance N, O, S, Se or Si, or a carbon atom may be replaced by these heteroatoms. The term "alicyclic" also includes cycloalkenyl moieties that are unsaturated cyclic hydrocarbons, which generally contain about three to about eight ring carbon atoms, for example five or six ring carbon atoms. Cycloalkenyl radicals typically have a double bond in the respective ring system. Cycloalkenyl radicals may in turn be substituted.

The term "aromatic" means, unless otherwise stated, a planar cyclic hydrocarbon moiety of conjugated double bonds, which may be a single ring or include multiple fused or covalently linked rings, for example, 2, 3 or 4 fused rings. The term aromatic also includes alkylaryl. Typically, the hydrocarbon (main) chain includes 5, 6, 7 or 8 main chain atoms in one cycle. Examples of such moieties include, but are not limited to, cylcopentadienyl, phenyl, naphthalenyl-, [10]annulenyl-(1,3,5,7,9-cyclodeca-pentaenyl-), [12]annulenyl-, [8]annulenyl-, phenalene (perinaphthene), 1,9-dihydropyrene, chrysene (1,2-benzophenanthrene). An example of an alkylaryl moiety is benzyl. The main chain of the cyclic hydrocarbon moiety may, unless otherwise stated, be of any length and contain any number of heteroatoms, as for instance N, O and S. Examples of such heteroarom containing moieties (which are known to the person skilled in the art) include, but are not limited to, furanyl-, thiophenyl-, naphtyl-, naphthofuranyl-, anthraxthiophenyl-, pyridinyl-, pyrrolyl-, quinolinyl, naphthoquinolinyl-, quinoxalinyl-, indolyl-, benzindolyl-, imidazolyl-, oxazolyl-, oxoninyl-, oxepinyl-, benzoxepinyl-, azepinyl-, thiepinyl-, selenepinyl-, thioninyl-, azecinyl- (azacyclodecapentaenyl-), diazecinyl-, azacyclododeca-1,3,5,7,9,11-hexaene-5,9-diyl-, azozinyl-, diazocinyl-, benzazocinyl-, azecinyl-, azaundecinyl-, thia[11]annulenyl-, oxacyclotrideca-2,4,6,8,10,12-hexaenyl- or triazaanthracenyl-moieties.

By the term "arylaliphatic" is meant a hydrocarbon moiety, in which one or more aromatic moieties are substituted with one or more aliphatic groups. Thus the term "arylaliphatic" also includes hydrocarbon moieties, in which two or more aryl groups are connected via one or more aliphatic chain or chains of any length, for instance a methylene group. Typically, the hydrocarbon (main) chain includes 5, 6, 7 or 8 main chain atoms in each ring of the aromatic moiety. Examples of arylaliphatic moieties include, but are not limited, to 1-ethyl-naphthalene, 1,1'-methylenebis-benzene, 9-isopropylanthraxcene, 1,2,3-trimethyl-benzene, 4-phenyl-2-buten-1-ol, 7-chloro-3-(1-methylethyl)-quinoline, 3-heptyl-furan, 6-[2-(2,5-diethylphenyl)ethyl]-4-ethyl-quinazoline or, 7,8-dibutyl-5,6-diethyl-isoquinoline.

Each of the terms "aliphatic", "alicyclic", "aromatic" and "arylaliphatic" as used herein is meant to include both substituted and unsubstituted forms of the respective moiety. Substituents my be any functional group, as for example, but not limited to, amino, amido, azido, carbonyl, carboxyl, cyano, isocyano, dithiane, halogen, hydroxyl, nitro, organometal, organoboron, seleno, silyl, silano, sulfonyl, thio, thiocyano, trifluoromethyl sulfonyl, p-toluenesulfonyl, bromobenzenesulfonyl, nitrobenzenesulfonyl, and methane-sulfonyl.

In some embodiments the at least one sealing layer conforms substantially to the shape of the defects present on the surface of the at least one barrier layer. The sealing layer may act as a planarising material that smoothens the surface of the substrate, thereby covering defects on the substrate which could provide pathways for the infiltration of moisture/oxygen.

The preceding embodiments relate to an encapsulation barrier stack in which the one or more nanoparticle sealing layers are immobilized, e.g. deposited onto only one side of a substrate. An encapsulation barrier stack may for instance also include a substrate that is sandwiched between two multilayer films.

As will be apparent from the above, an encapsulation barrier stack according to the invention has at least one nanoparticle sealing layer having an upper face and a lower face, defining a plane. Each layer further has a circumferential wall defining a thickness of the sealing layer. Any suitable thickness can be chosen for the nanoparticle sealing layers, for example a thickness of between about 50 nm (for example, using nanoparticles with a size of about 10 to about 20 nm) to about 1000 nm or even higher (if transparency of the sealing layer is of concern). In other embodiments, the nanoparticle sealing layer may have a thickness of about 250 nm to about 850 nm or of about 350 nm to about 750 nm. Typically, each sealing layer is of at least essentially uniform thickness. In some embodiments the circumference of each sealing layer is of at least essentially the same dimensions as the circumference of any other sealing layer. One embodiment of a barrier stack according to the invention has two (upper and lower) outer surfaces defined by the upper face of a first nanoparticle sealing layer and the lower face of a second nanoparticle sealing layer. These two surfaces are arranged on at least essentially opposing sides of the barrier stack. Each of these two surfaces defines a plane. In typical embodiments these two planes are essentially parallel to each other. Furthermore these two surfaces are exposed to the ambience.

The encapsulation barrier stack of the invention can be used in several ways for encapsulating a moisture and oxygen sensitive device. Any device may be encapsulated by an encapsulation barrier stack of the invention, such as an OLED, pharmaceutical drugs, jewellery, reactive metals, electronic components or food substances. For example, it can be arranged, for example laminated or deposited, onto a conventional polymer substrate that is used to support the OLED. As explained above, pinhole defects in the substrate are sealed by the polymer encapsulated nanoparticulate material of the sealing layer. The OLED may be arranged directly on the barrier stack, and for instance encapsulated under a cover such as a glass cover, for instance using rim sealing or thin-film encapsulation comprising the attachment of an encapsulation barrier stack over the OLED, hereinafter referred to as 'proximal encapsulation', is also possible. Proximal encapsulation is in particular suitable for flexible OLED devices. In such an embodiment the multilayer film of the encapsulation barrier stack conforms to the external shape of the OLED device.

An encapsulation barrier stack according to the invention may be produced by forming on one or more nanoparticle sealing layer on a substrate or on a (further) sealing layer. The sealing layer may be formed by mixing a polymerisable compound with a plurality of reactive nanoparticles as defined above. The plurality of nanoparticles may in some embodiments be a colloidal dispersion comprising nanoparticles dispersed in a suitable liquid such as an organic solvent. In some embodiments a polar solvent such as e.g. ethanol, acetone, N,N-dimethyl-formamide, isopropanol, ethyl acetate or nitromethane, or a non-polar organic solvent such as e.g. benzene, hexane, dioxane, tetrahydrofuran or diethyl ether (cf. also below). As explained above, in order to allow for encapsulation of the reactive nanoparticles, the polymerisable compound (which might be a monomeric compound) is present in such a low concentration in the sealing mixture that the polymerisable compound is adsorbed on the surface of the reactive particles, thereby coating the particles and avoiding formation of a (bulk) matrix that incorporates the entire reactive particles.

Often liquids are classified into polar and non-polar liquids in order to characterize properties such as solubility and miscibility with other liquids. Polar liquids typically contain molecules with an uneven distribution of electron density. The same classification may be applied to gases. The polarity of a molecule is reflected by its dielectric constant or its dipole moment. Polar molecules are typically further classified into protic and non-protic (or aprotic) molecules. A fluid, e.g. a liquid, that contains to a large extent polar protic molecules may therefore be termed a polar protic fluid. A fluid, e.g. a liquid, that contains to a large extent polar non-protic molecules may be termed a polar non-protic fluid. Protic molecules contain a hydrogen atom which may be an acidic hydrogen when the molecule is dissolved for instance in water or an alcohol. Aprotic molecules do not contain such hydrogen atoms.

Examples of non-polar liquids include, but are not limited to, hexane, heptane, cyclohexane, benzene, toluene, dichloromethane, carbon tetrachloride, carbon disulfide, dioxane, diethyl ether, or diisopropylether. Examples of dipolar aprotic liquids are methyl ethyl ketone, chloroform, tetrahydrofuran, ethylene glycol monobutyl ether, pyridine, methyl isobutyl ketone, acetone, cyclohexanone, ethyl acetate, isobutyl isobutyrate, ethylene glycol diacetate, dimethylformamide, acetonitrile, N,N-dimethyl acetamide, nitromethane, acetonitrile, N-methylpyrrolidone, methanol, ethanol, propanol, isopropanol, butanol, N,N-diisopropylethylamine, and dimethylsulfoxide. Examples of polar protic liquids are water, methanol, isopropanol, tert.-butyl alcohol, formic acid, hydrochloric acid, sulfuric acid, acetic acid, trifluoroacetic acid, dimethylarsinic acid [(CH₃)₂AsO(OH)], acetonitrile, phenol or chlorophenol. Ionic liquids typically have an organic cation and an anion that may be either organic or inorganic. The polarity of ionic liquids (cf. below for examples) is known to be largely determined by the associated anion. While e.g. halides, pseudohalides, BF₄⁻, methyl sulphate, NO₃⁻, or ClO₄⁻ are polar liquids, hexafluorophosphates, AsF₆⁻, bis(perfluoroalkyl)-imides, and [C₄F₆SO₃]⁻ are non-polar liquids.

The mixing of the polymerisable compound with the plurality of nanoparticles may in some embodiments be carried out in a polar organic solvent such as defined above. In one embodiment the polar organic solvent includes a mixture of isopropanol and ethyl acetate, for example in a molar ratio from about 2 : 1 to about 1 : 10, e.g. about 1 : 1, about 1 : 2, about 1 : 3, about 1 : 5 or about 1 : 10. The mixture of the polymerisable compound and the reactive nanoparticles may be applied onto the barrier layer, and the polymerisable compound may be polymerised to form a polymer. Polymerisation is allowed to occur under conditions that allow the nanoparticles to be encapsulated by the polymer formed, i.e. using a low concentration of the polymerisable compound and, for example, additionally subjecting the sealing mixture to sonication. The sealing solution may be web flight coated onto the barrier layer, for example, via a roll-to-roll process. The coating of barrier layer and sealing layer is repeated for a predetermined number of times to obtain a multilayer film with a desired barrier property. For example, a multilayer film comprising 5 paired layers may be obtained by oxide coating and web flight coating to be repeated 5 times to form 5 paired layer.

In some embodiments a surfactant is added to the mixture of the polymerisable compound and the plurality of nanoparticles. Numerous surfactants, which are partly hydrophilic and partly lipophilic; are used in the art, such as for instance alkyl benzene sulfonates, alkyl phenoxy polyethoxy ethanols, alkyl glucosides, secondary and tertiary amines such as diethanolamine, Tween, Triton 100 and triethanolamine, or e.g. fluorosurfactants such as ZONYL® FSO-100 (DuPont). A surfactant may for instance be a hydrocarbon compound, a hydroperfluoro carbon compound or a perfluorocarbon compound. It may for example be substituted by a sulfonic acid, a sulphonamide, a carboxylic acid, a carboxylic acid amide, a phosphate, or a hydroxyl group. Examples of a hydrocarbon based surfactant include, but are not limited to, sodium dodecyl sulfate, cetyl trimethyl-ammonium bromide, an alkylpolyethylene ether, dodecyldimethyl (3-sulfopropyl) ammonium hydroxide (C₁₂N₃SO₃), hexadecyldimethyl (3-sulfopropyl) ammonium hydroxide (C₁₆N₃SO₃), coco (amidopropyl)hydroxyl dimethylsulfobetaine (RCONH(CH₂)₃N⁺(CH₃)₂CH₂CH(OH)CH₂SO₃⁻ with R=C₈-C₁₈), cholic acid, deoxycholic acid, octyl glucoside, dodecyl maltoside, sodium taurocholate, or a polymer surfactant such as e.g. Supelcoat PS2 (Supelco, Bellefonte, PA, USA), methylcellulose, hydroxypropylcellulose, hydroxyethylcellulose, or hydroxypropylmethylcellulose. The surfactant may for instance be a hydrocarbon compound, a hydroperfluoro carbon compound or a perfluorocarbon compound (supra), which is substituted by a moiety selected from the group consisting of a sulfonic acid, a sulphonamide, a carboxylic acid, a carboxylic acid amide, a phosphate, or a hydroxyl group.

Examples of perfluorocarbon-surfactants include, but are not limited to, pentadecafluorooctanoic acid, heptadecafluorononanoic acid, tridecafluoroheptanoic acid, undecafluorohexanoic acid, 1,1,1,2,4,4,5,5,6,6,7,7,8,8,9,9,10,10,11,11,11-heneicosa-fluoro-3-oxo-2-undecanesulfonic acid, 1,1,2,2,3,3,4,4,5,5,6,6,6-tridecafluoro-1-hexane-sulfonic acid, 2,2,3,3,4,4,5,5-octafluoro-5-[(tridecafluorohexyl)oxy]-pentanoic acid, 2,2,3,3-tetrafluoro-3-[(tridecafluorohexyl)oxy]-propanoic acid], N,N'-[phosphinicobis(oxy-2,1-ethanediyl)]bis[1,1,2,2, 3,3,4,4,5,5,6,6,7,7,8,8,8-heptadecafluoro-N-propyl-1-octanesulfonamide, 1,1,2,2,3,3,4,4,5,5,6, 6,7,7,8,8,8-heptadecafluoro-1-octanesulfonic acid, 1,1,2,2,3,3,4,4,5,5,6,6,7,7,8,8,8-heptadecafluoro-1-octanesulfonyl fluoride, 2-[(β-D-galactopyranosyloxy)methyl]-2-[(1-oxo-2-propenyl)amino]-1,3-propanediyl carbamic acid (3,3,4,4,5,5,6,6,7,7,8, 8,8-tridecafluorooctyl)-ester, 6-(3,3,4,4,5,5,6,6,7,7,8,8,8-tridecafluorooctyl hydrogen phosphate)-D-glucose, 3-(3,3,4,4,5,5, 6,6,7,7,8,8,9,9,10,10,10-heptadecafluorodecyl hydrogen phosphate)-D-glucose, 2-(perfluorohexyl)ethyl isocyanate, 2,2,3,3,4,4,5,5,6,6,7,7,8,8,8-pentadecafluoro-N-phenyl-octanamide, 1,1,2,2,3, 3,4,4,5,5,6,6,7,7,8,8,9,9,10,10,11,11,12,12,12-pentacosafluoro-N-(2-hydroxyethyl)-N-propyl-1-dodecanesulfonamide, 2-methyl-,2-[[(heptadecafluorooctyl)sulfonyl]methylamino]-2-propenoic acid ethyl ester, 3-(2,2,3,3,4,4,5,5,6,6,7,7,8,8,8-pentadecafluoro-1-oxooctyl)-benzenesulfonic acid, 3-(heptadecafluorooctyl)-benzenesulfonic acid, 4-[(2,2,3,3,4,4,5,5,6,6,7,7,8,8,8-pentadecafluoro-1-oxooctyl)amino]-benzenesulfonic acid, 3-[(o-perfluorooctanoyl)phenoxy]propanesulfonic acid, N-ethyl-1,1,2,2,2-pentafluoro-N-(26-hydroxy-3,6,9,12,15,18,21,24-octaoxahexacos-1-yl)-ethanesulfonamide, 3-[ethyl[(heptadecafluorooctyl)sulfonyl]amino]-1-propanesulfonic acid, 1,2,2,3,3, 4,5,5,6,6-decafluoro-4-(pentafluoroethyl)-cyclohexanesulfonic acid, 2-[1-[difluoro(pentafluoroethoxy)methyl]-1,2,2,2-tetrafluoroethoxy]-1,1,2,2-tetrafluoro-ethanesulfonic acid, N-[3-(dimethyloxidoamino)propyl]-2,2,3,3,4,4-hexafluoro-4-(heptafluoropropoxy)-butanamide, N-ethyl-N-[(heptadecafluorooctyl)sulfonyl]-glycine, or 2,3,3,3-tetrafluoro-2-[1,1,2,3,3,3-hexafluoro-2-[(tridecafluorohexyl)oxy]propoxy]-1-propanol, to name a few.

Examples of perfluorocarbon-surfactants also include polymeric compounds such as α-[2-[bis(heptafluoropropyl)amino]-2-fluoro-1-(trifluoromethyl)-ethenyl]-ω-[[2-[bis(heptafluoropropyl)amino]-2-fluoro-1-(trifluoromethyl)ethenyl]oxy]- poly-(oxy-1,2-ethanediyl), α-[2-[[(nonacosafluorotetradecyl)sulfonyl]propylamino]ethyl]-ω-hydroxy-poly(oxy-1,2-ethanediyl), polyethylene glycol diperfluorodecyl ether, α-[2-[ethyl-[(heptadecafluorooctyl)sulfonyl]amino]ethyl]-ω-hydroxy-poly(oxy-1,2-ethanediyl), α-[2-[ethyl[(pentacosafluorododecyl)sulfonyl]amino]ethyl]-ω-hydroxy-poly(oxy-1,2-ethanediyl), α-[2-[[(heptadecafluorooctyl)sulfonyl]propylamino]ethyl]-α-hydroxy-poly(oxy-1,2-ethanediyl), N-(2,3-dihydroxypropyl)-2,2-difluoro-2-[1,1,2,2-tetrafluoro-2-[(tridecafluorohexyl)oxy]ethoxy]-acetamide, α-(2-carboxyethyl)-ω-[[(tridecafluorohexyl)oxy]methoxy]-poly(oxy-1,2-ethanediyl),α-[2,3,3,3-tetrafluoro-2-[1,1,2, 3,3,3-hexafluoro-2-(heptafluoropropoxy)propoxy]-1-oxopropyl]-ω-hydroxy-poly(oxy-1,2-ethanediyl), and 2,3,3,3-tetrafluoro-2-(heptafluoropropoxy)-propionic acid polymer.

In some embodiments a surface modifying compound such as a silane is added to the sealing mixture. Examples of suitable silanes include acetoxy, alkyl, amino, amino/alkyl, aryl, diamino, epoxy, fluroalkyl, glycol, mercapto, methacryl, silicic acid ester, silyl, ureido, yinyl, and vinyl/alkyl silanes.

Illustrative examples of such silanes include, but are not limited to, di-tert-butoxydiacet-oxysilane, hexadecyltrimeth-oxysilane, alkylsiloxane, Bis(3-triethoxysilylpropyl) amine, 3-aminopropyl-methyldiethoxysilane, triamino-functional propyltrimethoxysilane, phenyltrimethoxysilane, phenyltriethoxysilane, 2-aminoethyl-3-amino-propylmethyl, dimethoxysilane, 2-aminoethyl-3-amino-propyl, trimethoxysilane, proprietary aminosilane composition, 3-glycidyloxy, propyltriethoxysilane, tridecafluoroocty-ltriethoxysilane, polyether-functional trimethoxysilane, 3-mercaptopropyltri-methoxysilane, 3-methacryloxypropyl-trimethoxysilane, ethyl polysilicate, tetra-n-propyl orthosilicate, hexamethyl-disilazane, vinyltrichlorosilane, vinyltrimethoxysilane, vinyl-functional oligosiloxane, 3-methacryloxypropyltrimethoxysilane and combinations thereof.

In some embodiments forming the sealing layer is carried out under an inert atmosphere, which may for example include or consist of nitrogen, argon, neon, helium, and/or sulfur hexafluoride (SF₆).

In one embodiment, a method of manufacturing an encapsulation barrier stack of the invention comprises:
- providing a substrate, wherein the substrate is not a barrier layer, and
- forming a film layer that comprises one or more nanoparticle sealing layer(s), wherein forming the one or more nanoparticle sealing layer(s) comprises
   (i) mixing an encapsulation material consisting of or comprising of dendrimers or precursors thereof, dendrons or precursors thereof, optionally in the presence of a polymerizable compound and/or a cross-linkable compound, with a plurality of nanoparticles, the nanoparticles being reactive in that they are capable of interacting with moisture and/or oxygen, thereby forming a sealing mixture,
   (ii) applying the sealing mixture onto the substrate under conditions that allow the nanoparticles to be encapsulated by or in the dendrimers, thereby forming the sealing layer.

In one embodiment of this method the dendrimers are dendrimers or hyper-branched polymers comprising one or more of the following: secondary amine (-NH-) or primary amine (-NH₂) groups, hydroxyl group (-OH), carboxylic acid (--COOH),-COONH₂, -COCI, CI, Br or I or F, thiols (SH), or more preferably amine or hydroxyl group. These groups such as an amine or hydroxyl group may coupled to molecules comprising one or more of the following; (-COOH), (-COHal); or (-COOC₁-C₂₀ alkyl) to provide modified dendrimers and wherein Hal is selected from I, Br, Cl and F.

In illustrative embodiments of this methods the dendrimers are selected from poly(amidoamines) (PAMAM), polyethylene imines (PEI), poly(propyleneimines) (PPI), and polypropyleneimine dotriacontaamine dendrimers (DAB) and Frechet dendrimers.

The encapsulation material that is used in this embodiment may further comprise one or more of the following: an organic polymerizable compound, an inorganic polymerizable compound, a water soluble polymerizable compound, an organic solvent soluble polymerizable compound, a biological polymer, a synthetic polymerizable compound, a monomer, an oligomer, a surfactant and/or organic compounds that are cross linkable compounds, a solvent or mixture of solvents. In cases where an organic polymerizable compound is employed, this organic polymerizable compound is preferably selected from acrylic acid, methyl acrylate, ethyl acrylate or butyl acrylate or any mixture thereof.

As explained above, the encapsulation of the nanoparticles may be carried out in the presence of a cross-linkable compound. In some embodiments of this methods, the cross linkable compound includes, for example, a mercapto group, an epoxy group, an acrylic group, a methacrylate group, an allyl group, a vinyl group, and/or an amino group. By so doing, crosslinked dendrimer encapsulated nanoparticles may be formed. In addition, linking between dendrimer encapsulated nanoparticles may be also achieved via cross linkers that are cross-linkable compounds that form a "linker unit" with the surface group of the dendrimer/dendron. Cross-linkable compounds are, for example, monomers or oligomers or compounds comprising a linker unit as defined below. Linking or cross-linking between dendrimer encapsulated nanoparticles can, for example, be obtained by reacting the surface group of the dendrimer or dendron with crosslinking/cross-linkable compounds. The crosslinking compound (such as PEG or a silane such as (3-acryloxypropyl)methyldimethoxysilane) or methacryloxypropyltrimethoxysilane) may be bonded to the outer shell of the dendrimer/dendron (e.g. via the surface group of the dendrimer/dendron) before the encapsulation step. Hence, the crosslinking (after the cross-linking reaction) between dendrimer encapsulated nanoparticles may be a direct link between the surface groups of distinct dendrimer encapsulated nanoparticle. Alternatively, the crosslinking may be "mediated" by cross-linkable compounds (e.g. bi-functionalized compounds, monomers, or PEG, to name only a few examples. It is noted here that the dendrimer used in the present invention might also be photocurable. An example of such a dendrimer is a PAMAM dendrimer G3.0 to which polyethylene glycol (PEG) chains of various lengths (MW=1500, 6000, or 12000 gmol⁻¹) can be coupled and the resulting PEGylated PAMAM dendrimers can be further coupled with acrylate groups to yield photoreactive dendrimer macromonomers (cf. in respect Desai et al., Biomacromolecules 2010 March 8; 11(3): 666-673. Another example of photocurable dendrimers are photo cross-linkable poly(glycerol-succinic acid)-co-poly-(ethylene glycol) dendrimers (first-generation (G1) dendritic polymer, ([G1]-PGLSA-MA)2-PEG) described in Degoricija et al. Investigative Ophthalmology & Visual Science, May 2007, Vol. 48, No. 5, pages 2037-2042).

Linking of the dendrimer molecules may also be obtained through non-covalent bonding, such as ionic or dipole-dipole interactions or metal-ion complexation. The "linker units" or "cross linker units" may be coupled to the dendrimer molecule by appropriate spacer units (e.g. cross linking compounds). Preferably the "linker units" are selected from thiol groups, disulphide groups, amino groups, isocyanide groups, thiocarbamate groups, dithiocarbamate groups, chelating polyether or carboxyl groups. Within the dendrimer molecule the linker units may be of the same or of different type. In line with this disclosure, the term "cross-linkable compound" as used in the present invention encompasses any compound that has two reactive groups (or linking units) that are able to react with the encapsulation material, for example, a dendrimer or a curable monomer or oligomer) and that, for example, comprises at least two reactive groups such as, but not limited to, a mercapto group, an epoxy group, an acrylic group, a methacrylate group, an allyl group, a vinyl group, an amino group, a thiol group, a disulphide group, an isocyanide group, a thiocarbamate group, a dithiocarbamate group, a chelating polyether or an carboxyl group. Reverting to the embodiments that may use dendrimers as encapsulation material, also a respective method of manufacturing a barrier stack of the invention may further comprise adding a surface modifying compound to the sealing mixture. The surface modifying compound may, for example, be a silane.

In embodiments of the method of the invention providing the one or more substrate may comprise forming the one or more substrate.

Also in these embodiments of the method the conditions and/or the concentration of the polymerizable compound, if present, is typically chosen such that the polymerizable compound is immobilized on the surface of the reactive nanoparticles. In typical embodiments the sealing mixture is applied onto the substrate via conformal deposition. The sealing mixture may be applied onto the barrier layer by any suitable conformal deposition method, including but not limited, to spin coating, screen printing, a WebFlight method, slot die, curtain gravure, knife coating, ink jet printing, screen printing, dip coating, plasma polymerisation or a chemical vapour deposition (CVD) method.

In this embodiment, the sealing layer is, after being deposited onto the substrate, usually exposed to conditions that initiate polymerization of the polymerisable compound or cross-linking the cross-linkable compound. The conditions that initiate polymerization may include, but are not limited to, UV radiation or IR radiation, electron beam curing, plasma polymerisation (for curing of the polymerisable compound or crosslinking the cross-linkable compound). In one embodiment of this method, the one or more sealing layer(s) formed at least essentially consist(s) of the dendrimer encapsulated reactive nanoparticles. In typical embodiments of embodiments of methods of the invention (regardless of the type of encapsulation material that is used) the method comprises carrying out sonication of the sealing mixture prior to encapsulation by e.g. polymerisation The sonication is carried out for any suitable time (which can be experimentally determined), for example, for at least about 30 minutes.

In the manufacturing methods, the nanoparticles may be used in a colloidal dispersion comprising the nanoparticles dispersed in an organic solvent. The encapsulation compound may be present in a polar organic solvent and/or the nanoparticles are suspended in a solvent, preferably a polar organic solvent. In one purely illustrative example, the polar organic solvent comprises a mixture of isopropanol and ethyl acetate in 1 : 3 molar ratio. In embodiments of the method of making a barrier stack of the invention mixing of the encapsulation material with the nanoparticles in step (i) comprises mixing about 20 wt.-% dry form or less of the encapsulation material to 80 wt.-% dry form of the nanoparticles (weight ratio 1:4 or less). In some embodiments the encapsulation material is mixed with the nanoparticles at a weight ratio of 1: 5 or less. A sealing mixture so obtained in step (i) of the method described above may comprise 10 % (w/v) or less of the encapsulation material. In some embodiments, the sealing mixture comprises about 5 % (w/v) of the encapsulation material.

As one of ordinary skill in the art will readily appreciate from the disclosure of the present invention, other compositions of matter, means, uses, methods, or steps, presently existing or later to be developed that perform substantially the same function or achieve substantially the same result as the corresponding exemplary embodiments described herein may likewise be utilized according to the present invention.

### EXEMPLARY EMBODIMENTS

Typical embodiments of a barrier stack design of the present invention include forming one or more sealing layer of functionalized nanoparticles on planarized or non-planarized plastic substrates (stretchable or non-stretchable). For example, functionalized nano-particles consist of polymer-encapsulated nanoparticles and/or functionalized nanoparticle with organic species that may be deposited on to substrate as a functionalized nanoparticle layer. The functionalized nanoparticles can penetrate into the pores of the substrate and enhance the barrier properties (against permeation of water vapour (moisture) and/or oxygen, for example). A combination of mutually chemically interconnected organic and inorganic nanoparticles results in coatings with very low permeability of gases. If polymer is encapsulated on to the nanoparticle, the ratio of polymer and nanoparticles by weight is preferably 1:4 or less, 1:5 or less, or 1:6 or less, 1:9 or less, or 1:15 or less, or 1:19 or less than 1:19. Thus, in this invention, the amount of organic species or polymer content of the encapsulation is reduced to a minimum and the encapsulation can be only partial. In one embodiment, the encapsulation material used enhances the bond strength between two particles and enhances oxygen and moisture barrier properties. The encapsulation material is only 50 to 90% of the area of the nanoparticle or by total weight and therefore, the moisture or oxygen is adsorbed on the encapsulation material and the nanoparticle can react with the oxygen and moisture. Therefore, the overall permeation through barrier layers is minimized. The encapsulated nanoparticle layer thickness is preferably in a range of 80 nm to few microns, e.g. 1, 2, 3, 4 5, 6, 7, 8 or, 9 or 10 micrometres.

Salient features of the invention include:

The porous polymer content is very low in the nanoparticle sealing layer and each nanoparticle is at least partially encapsulated with an organic material or a polymer or a monomer, dendrimer or an organo-metallic compound. However, the nanoparticles packing density is very good and the bond strength between the nanoparticles is excellent and the peel strength of tested barrier stacks of the invention passed ASTM standard.

For tested samples, the barrier properties of the single nanoparticle layer is 10⁻²g/m².day to 10⁻³g/m²·day and multi-layer nanoparticle layer may achieve less than 10^{- 4}g/m²·day at 39°C and 90% relative humidity. The oxygen barrier properties for a tested single barrier layer are 10⁻³cc/m²·day·atm at ambient and for a tested multi-layer barrier stack 10⁻⁴cc/m²·day·atm.

The multi-layer nanoparticle layers can plug the coating defects and or surface defects and increase the barrier properties significantly. In addition, a first nanoparticle sealing layer may be a moisture barrier and a second nanoparticle layer may be an oxygen barrier.

Tensile tests (ASTM D882) of exemplary embodiments show that the stretchability (or elongation) of a single nanoparticle barrier layer formed on a PET substrate is less than 5% axial strain and the moisture barrier properties before and after the tensile test is less than 0.02g/m²·day at 39°C and 90% relative humidity.

In line with the above, the functionalized nanoparticle layer (Nano-layer) can be a multi-nanolayer. These functionalized multi-nanolayers can act as a barrier layers and can also act as a UV blocking layer, anti-reflection layer, to enhance the mechanical properties, which includes adhesion, stretchability, weatherablity and optical properties.

For example, the first functionalized nanoparticle layer can be a defect sealing layer and anti-reflection layer and the second layer can be a UV blocking layer and third layer may be a light extraction layer. Therefore, in one barrier stack, multi-functional properties can be obtained. For example, in one embodiment, the defect-sealing layer(s) may consist of polymer encapsulated titanium nanoparticles, zinc nanoparticles, silica or hollow silica particles. These (polymer encapsulated) particles can be used to enhance the barrier properties of the stack, to block the UV light and have anti-reflection properties in the visible region.

### Functionalization Nanoparticles Layer or Multi-Nano layers

### Substrate Materials

Materials that may be used in the base substrate in the present invention include both organic and inorganic polymers. Examples of organic polymers which are suitable for forming the base substrate include, but are not limited to, both high and low permeability polymers such as cellophane, poly(1-trimethylsilyl-1-propyne, poly(4-methyl-2-pentyne), polyimide, polycarbonate, polyethylene, polyethersulfone, epoxy resins, polyethylene terephthalate (PET), polystyrene, polyurethane, polyacrylate, and polydimethylphenylene oxide. Microporous and macroporous polymers such as styrenedivinylbenzene copolymers, polyvinylidene fluoride (PVDF), nylon, nitrocellulose, cellulose or acetate may also be used. Examples of inorganic polymers which are suitable in the present invention include silica (glass), nano-clays, silicones, polydimethylsiloxanes, biscyclopentadienyl iron, polyphosphazenes and derivatives thereof. The base substrate may also include or consist of a mixture or a combination of organic and/or inorganic polymers. These polymers can be transparent, semi-transparent or completely opaque.

### Surface Preparation

The substrates used in the experimental part are rinsed with isopropyl alcohol (IPA) and blow-dried with nitrogen. These processes help to remove macro scale adsorbed particles on the surface. Acetone and methanol cleaning or rinsing is not recommended. After nitrogen blow-dry, the substrates are placed in the vacuum oven, with the pressure of 10-1mbar, for degassing absorbed moisture or oxygen. The vacuum oven is equipped with fore line traps to prevent hydrocarbon oil back migrating from vacuum pump to the vacuum oven. Immediately after the degassing process, the substrates are transferred to the plasma treatment chamber (e.g. ULVAC SOLCIET Cluster Tool). RF argon plasma is used to bombard the surface of the barrier film with low energy ions in order to remove surface contaminants. The base pressure in the chamber was maintained below 4 x 10⁻⁶ mbar. The argon flow rate is 70sccm. The RF power is set at 200 W and an optimal treatment time usually 5 to 8 eight minutes is used depending on the surface condition.

### Functionalized Nanoparticle Layer

The surface modification is a key aspect in the use of nanosized materials (also referred to as nanomaterials here). It is the surface that makes the nanosized materials significantly more useful than conventional non-nanomaterials. As the size of the material decreases, its surface-to-volume ratio increases. This presents considerable advantage to modify properties of nanomaterials through surface functionalization techniques. The functionalized nanoparticles are inclusive of polymer encapsulation on to the nanoparticle and organic species passivated nanoparticles. The functionalization techniques, which includes non-covalent (physical) bond and covalent bond (chemical) that can be applied to the nanoparticles. There are several methods available. Ultrasonic cavitation can be used to disperse nano-sized particles into solvent.

Covalent functionalization has been widely investigated and has produced an array of modified nanomaterial bearing small molecules, polymers and inorganic/organic species. Since nanomaterials, although quite small, are much larger than molecules, organic molecules can be used to modify the surfaces of these small particles. In addition to controlling the shape and size of the nanoparticles, controlling the surface of nanomaterial with organic chemistry has played a key role in the barrier stack design.

Surfactants, polymeric surfactants or polymers are employed to passivate or encapsulate the surface of the nanoparticles during or after the synthesis to avoid agglomeration. Generally electrostatic repulsion or steric repulsion can be used to disperse nanoparticles and keep them in a stable colloidal state. Also, surfactants or polymers can be chemically anchored or physically adsorbed on nanomaterials to form a layer stabilization and specific functionalization.

In one embodiment, the methodology for the preparation of polymer encapsulated nanoparticles is explained as below:

The commercially available surface functionalized nanoparticles can be selected according to the desired application. Illustrative examples of surface functionalized nanoparticles include, but are not limited, to 1-Mercapto-(triethylene glycol) methyl ether functionalized Zinc nanoparticles ethanol, colloidal dispersion w/ dispersant, Aluminum oxide, NanoDur™ X1130PMA, 50% in 1,2-propanediol monomethyl ether acetate, colloidal dispersion, Zinc oxide, NanoArc® ZN-2225, 40% in 1,2-propanediol monomethyl ether acetate, colloidal dispersion with dispersant, Zinc oxide, NanoTek® Z1102PMA, 50% in 1,2-propanediol monomethyl ether acetate, colloidal dispersion with dispersant. Examples of silane compounds are inclusive of, but not limited to, alkali, amino, epoxy, and methacryl silanes.

A polymer coating can be established on the nanoparticle core via covalent bonding or physical bonding, for example, by means of in situ polymerized monomers or pre-polymers in a discontinuous phase of an inverse mixture. A so obtained polymer-encapsulated nanoparticle may have a size ranging from about 20 nm to about 1000 nm.

In one embodiment, the above surface functionalized aluminium oxide (NanoDur) nanoparticles (20ml) are mixed in the ethyl acetate (10ml), 3-Methacryloxypropyltrimethoxysilane (10ml) and surfactant (0.5% by weight). A THINKY ARE-250 mixer (available from INTERTRONICS, Oxfordshire, United Kingdom) can be used to undertake the mixing of the above mentioned solution. The sonication time is typically 2 hours at 28 °C. After that, the monomer can be added by 0.5% to 6% by weight of the total solution. The sonication can typically be undertaken for 2 hours to 12 hours. The monomer is diluted in the solvent and adsorbed and chemically anchored on the nanoparticles during the sonication process.

The coating process can, for example, be undertaken by spin coating, inkjet printing, slot die coating, gravure printing or any other wet coating processes known to the person skilled in the art. Then the monomer is cured under UV or heat curing or EB curing processes.

The functionalized nanoparticles can penetrate effectively in to pores or the defects of a substrate and plug defects. And they also improve the bond strength between the nanoparticles in the functionalized nanoparticle sealing layer. The high packing density of the nanoparticle coating can be obtained by a suitable functionalization techniques (coating thickness in the range of 50nm to a few microns) on to the substrate films. The thickness of the sealing layer of the functionalized nanoparticles may be determined based on the type of defects present in the surface of the plastic substrate.

In a preferred embodiment, the majority of the polymer coated nano-particles of metal or metal oxide particles and organic species passivated nanoparticles, which include metal and metal oxide, are rod like with a diameter of 10 to 50 nm and length up to 200nm. The diameter and size of the particles may be chosen in such a way that they do not influence the transparency of the eventual coatings. The packing density of the nanoparticles is determined by the shape and size distribution of the nanoparticles. Therefore, it may be advantageous to use nanoparticles of different shapes and sizes to precisely control the surface nano-structure for the effective barrier properties and interaction with oxygen and moisture.

Polymer encapsulated Carbon nanotubes (CNTs)/carbon particles, graphene nanosheets or graphene flakes can be also used to react with oxygen and moisture. Typically it is advantageous to employ the maximum amount of absorbent particles in order to increase the ability to absorb and retain water and oxygen molecules.

### Experimental Details & Results

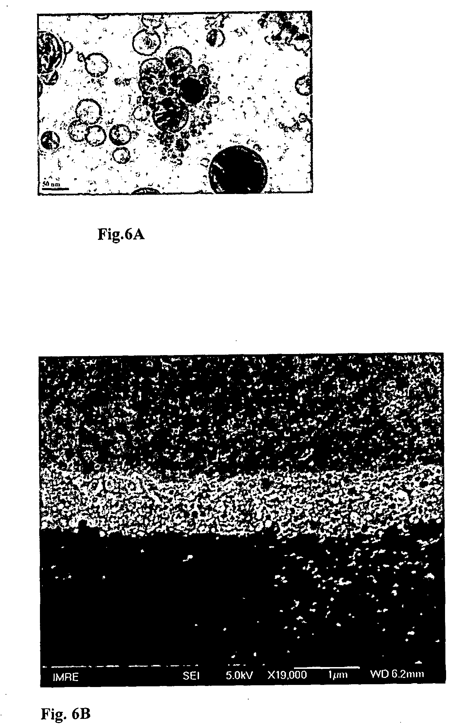

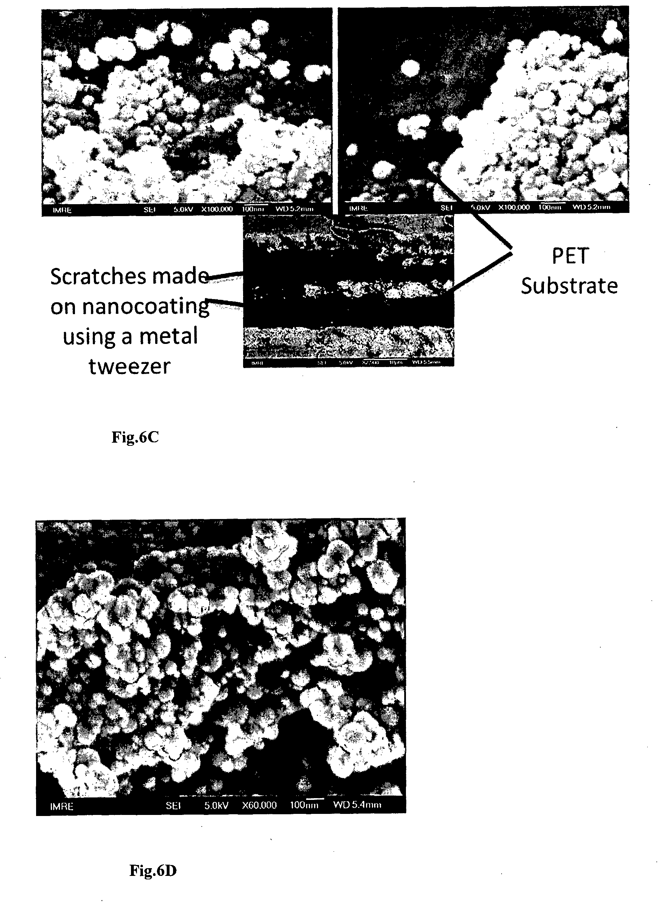

### Polymer encapsulated nanoparticles layer (cf. Figs 5 and 6) - Surface topography

In one example, a solvent mixture of IPA:Ethyleactate in the ratio 5:15 ml is mixed, and 3-Methacryloxypropyltrimethoxysilane (10 ml) added. The surfactant Dow Corning® FZ 2110 is further added to 0.5% by total weight of the solution and the solution mixed. The UV curable acrylate monomer (Addison Clear Wave) - 3 ml is then added to the above mixture. The mixture is kept in sonication for 2 hours. The surface functionalized nanoparticle "Aluminum oxide, NanoDur™ X1130PMA, 50% in 1,2-propanediol monomethyl ether acetate"- 20 ml were added to the solvent/monomer mixture and the mixture then sonicated for few hours. The resulting mixture was then spin coated and cured. The formulation was undertaken under inert gas environment. The set of experiments was carried out with different mixtures of nanoparticles and spin coated onto a plain PET polymer substrate. **Fig. 5** and **Fig. 6** show the surface morphology of the coated polymer encapsulated nanoparticles, with **Fig. 5A** showing polymer encapsulated aluminum oxide nanoparticle (NanoDur™ X1130PMA) with a size of 20 to 30 nm formed on a polyethylene terephthalate (PET) substrate having a width of 300 mm and a length of 300 m, **Fig. 5B** showing polymer encapsulated aluminum oxide nanoparticles with a size of 40 to 80nm with a transparency of 95% and the thickness of the nanoparticle sealing layer in the range of 350nm to 400nm, **Fig. 6A** showing a transmission electron microscopy (TEM) image of the aluminum oxide (NanoDur™ X1130DPMA) nanoparticles distributed in polymer solution prior to encapsulation, **Fig. 6B** showing a scanning electron microscope (SEM) image showing the cross section of polymer encapsulated aluminum oxide nanoparticles deposited onto the PET substrate and **Figs. 6C** and **6D** showing SEM images of a sealing layer of encapsulated aluminum oxide nanoparticles in which scratches have been made by tweezers. Scratching the nanoparticles served two purposes. First, it demonstrates that each nanoparticle is individually encapsulated by polymer (**Fig. 6C**). Second, in the SEM image the cross-section of the nanoparticle layer can be seen (**Fig. 6D**).

### Embodiment 1

1. Plastic substrate - PET
2. Polymer encapsulated nanoparticle sealing layer with one type of nanoparticles

Nano Solution Preparation: The solvent IPA:Ethyleactate 5:15 ml ratio is mixed, and 3-Methacryloxypropyltrimethoxysilane (10ml) added and then surfactant Dow Corning® FZ 2110 is further added by 0.5% by total weight of the solution and mixed. The UV curable acrylate monomer (Addison Clear Wave) - (3ml) is then added to the above mixture. The mixture is kept in sonication for 2 hours. The surface functionalized nanoparticle "Aluminum oxide, NanoDur™ X1130PMA, 50% in 1,2-propanediol monomethyl ether acetate"- 20ml is added to the solvent/monomer mixture and sonicated for a few hours. The above mixture was then spin-coated and cured. The formulation was undertaken under inert gas environment. The set of experiments was carried out with different mixtures of nanoparticles and deposited onto a PET substrate by spin coating or by slot die coating (Roll to Roll coating).

### Embodiment 2

1. Plastic substrate - PET
2. Polymer encapsulated nanoparticle sealing layer with two different types of nanoparticles

Nano Solution Preparation: The solvent IPA:Ethyleactate (5:15 ml) ratio is mixed, and 3-Methacryloxypropyltrimethoxysilane (10ml) is added and then surfactant Dow Corning® FZ 2110 is further added by 0.5% by total weight of the solution and mixed. The UV curable acrylate monomer (Addison Clear Wave) - (3ml) is then added to the above mixture. The mixture kept is in sonication for 2 hours. The surface functionalized nanoparticle "Aluminum oxide, NanoDur™ X1130PMA, 50% in 1,2-propanediol monomethyl ether acetate"- 20ml added to the solvent/monomer mixture and sonicated for few hours. The formulation was undertaken under inert gas environment. Barium titanium ethylhexano-isopropoxide in isopropanol is used to produce 5% BaTiO₃ and to this mixture is added 3-Methacryloxypropyltrimethoxysilane and surfactant Dow corning FZ 2110 and sonicated for 2 hours. A THINKY ARE-250 mixer (see above) is then used to mix the above Al₂O₃ mixture and BaTiO₃ mixtures before the coating process (Slot die Roll to Roll process). The set of experiments was carried out with different mixture of nanoparticles which were deposited by slot die coating onto the plain polymer substrate

### Embodiment 3

1. Plastic substrate - PET
2. Polymer encapsulated nanoparticle sealing layer 1 (comprising encapsulated aluminum oxide nanoparticles and encapsulated barium titanate nanoparticles)
3. Polymer encapsulated nanoparticle sealing layer 2 (comprising encapsulated zinc oxide nanoparticles and encapsulated titanium oxide nanoparticles)

Nano Solution Preparation: The solvent IPA:Ethyleactate (5:15 ml ratio) is mixed, and 3-methacryloxypropyltrimethoxysilane (10ml) added and surfactant Dow Corning® FZ 2110 is further added by 0.5% by total weight of the solution and mixed. The UV curable acrylate monomer (Addison Clear Wave) - (3ml) is then added to the above mixture. The mixture is kept in sonication for 2 hours. The surface functionalized nanoparticle "Aluminum oxide, NanoDur™ X1130PMA, 50% in 1,2-propanediol monomethyl ether acetate"- 20ml is added to the solvent/monomer mixture and sonicated for few hours. The formulation was undertaken under inert gas environment. Barium titanium ethylhexanol-isopropoxide in isopropanol was used to produce 5% BaTiO₃ and to this mixture 3-methacryloxypropyltrimethoxysilane and surfactant Dow corning FZ 2110 were further added and sonicated for 2 hours. A THINKY-ARE 250 mixer (see above) was then used to mix the above Al₂O₃ mixture and BaTiO₃ mixtures before the coating process that forms sealing layer 1. The set of experiments was carried out with different mixtures of nanoparticles and deposition of layer 1 was carried out by slot die coating (Roll to Roll) onto the plain polymer (PET) substrate.

For formation of sealing layer 2, Zinc oxide, NanoTek® Z1102PMA, 50% in 1,2-propanediol monomethyl ether acetate, colloidal dispersion with dispersant, 20ml was used and 3-Methacryloxypropyltrimethoxysilane (10ml) were added and surfactant Dow corning FZ 2110 is further added by 0.5% by total weight of the solution and mixed. The UV curable acrylate monomer (Addison Clear Wave) - (3ml) were then added to the above mixture. The mixture was kept in sonication for 2 hours. The formulation was undertaken under inert gas environment. Titanium in isopropanol to produce 5% of titanium oxide and 3-Methacryloxypropyltrimethoxysilane and then doped surfactant Dow corning FZ 2110 were added. This mixture was sonicated for 2 hours. A Thinky ARE-250 mixer was used to mix the above ZnO mixture and TiO₂ mixtures before forming sealing layer 2 by the coating process.

### Embodiment 4

1. Plastic substrate - PET
2. Polymer encapsulated nanoparticle sealing layer 1 (comprising encapsulated Al₂O₃ nanoparticles and encapsulated BaTiO₃ nanoparticles)
3. Polymer encapsulated nanoparticle sealing layer 2 (comprising encapsulated zinc oxide nanoparticles and encapsulated titanium oxide nanoparticles)
4. Polymer encapsulated nanoparticle sealing layer 3 (comprising encapsulated Al₂O₃ nanoparticles and encapsulated BaTiO₃ nanoparticles)

Nano Solution Preparation: The solvent IPA:Ethyleactate (5:15 ml) ratio is mixed, and 3-Methacryloxypropyltrimethoxysilane (10ml) and surfactant Dow corning FZ 2110 was further added by 0.5% by total weight of the solution and mixed. The UV curable acrylate monomer (Addison Clear Wave) - (3ml) was then added to the above mixture. The mixture is kept in sonication for 2 hours. The surface functionalized nanoparticle "Aluminum oxide, NanoDur™ X1130PMA, 50% in 1,2-propanediol monomethyl ether acetate"- 40ml was added to the solvent/monomer mixture and sonicated for few hours. The formulation was undertaken under inert gas environment. Barium titanium ethylhexano-isopropoxide in isopropanol was used to produce 5% BaTiO₃ and 3-methacryloxypropyltrimethoxysilane added and surfactant Dow corning FZ 2110 was further added and sonicated for 2 hours. A Thinky ARE 250 mixer was then used to mix the above Al₂O₃ mixture and BaTiO₃ mixture before forming sealing layer 1 by the coating process.

For formation of sealing layer 2, the Zinc oxide, NanoTek® Z1102PMA, 50% in 1,2-propanediol monomethyl ether acetate, colloidal dispersion with dispersant, 20 ml is used and 3-methacryloxypropyltrimethoxysilane (10ml) was added and surfactant Dow corning FZ 2110 was further added by 0.5% by total weight of the solution and mixed. The UV curable acrylate monomer (Addision Clear Wave) - 3ml was then added to the above mixture. The mixture was kept in sonication for 2 hours. The formulation was undertaken under inert gas environment. Titanium in isopropanol to produce 5% of titanium oxide and 3-Methacryloxypropyltrimethoxysilane were added and then doped surfactant Dow corning FZ 2110. This mixture was sonicated for 2 hours. A Thinky ARE 250 mixer was used to mix the above ZnO mixture and TiO₂ mixture before forming sealing layer 2 by the coating process. Sealing layer 3 consisted of the encapsulated Al₂O₃ nanoparticles and encapsulated BaTiO₃ nanoparticles that were used for sealing layer 1, so that the coating process described for sealing layer 1 was repeated for formation of sealing layer 3.

**Table 1**

| No | Structure | WVTR at 60°C & 90% RH | OTR at Ambient | Elongati on | Adhesion (ASTM D-3359) |
|---|---|---|---|---|---|
| 1 | Embodiment 1 | 1 x 10⁻²g/m²·day | 3x10⁻³cc/m²·day·atm | less than 3% | 5 |
| 2 | Embodiment 2 | less than 10⁻²g/m² ·day | less than 10⁻³cc/m²·day·atm | less than 3% | 5 |
| 3 | Embodiment 3 | less than 10⁻⁴g/m²·day | less than 10⁻⁴cc/m²·day·atm | less than 3 % | 5 |
| 4 | Embodiment 4 | less than 10⁻⁴g/m²·day | less than 10⁻⁴cc/m²·day·atm | less than 3 % | 5 |

| | | | | | |
|---|---|---|---|---|---|
| WVTR: Water vapour transmission rate OTR: Oxygen transmission rate | | | | | |

The adhesion test the results of which are shown in Table 1 was performed as per ASTM D-3359.

### Stretchability Test (ASTM D 882) - Results

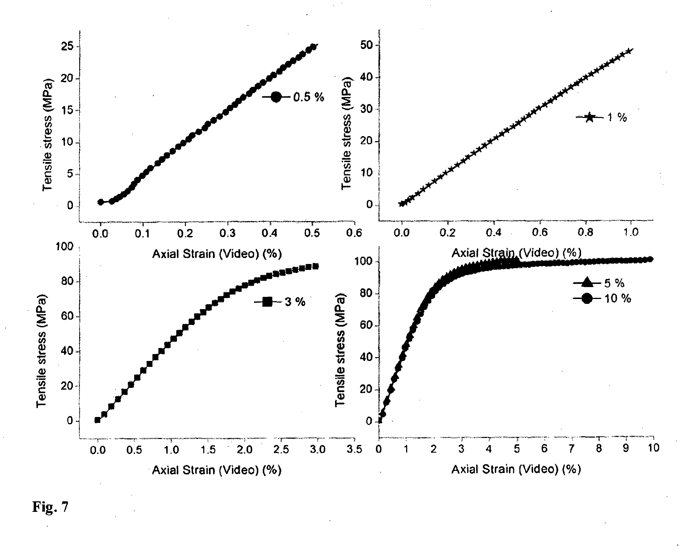

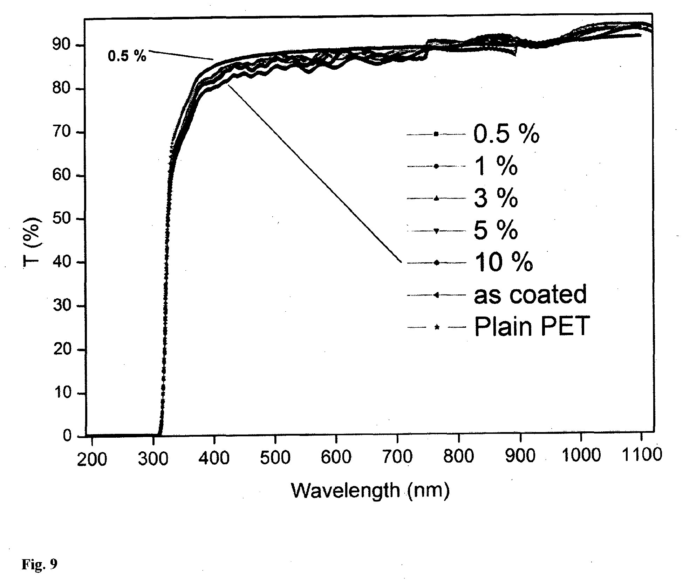

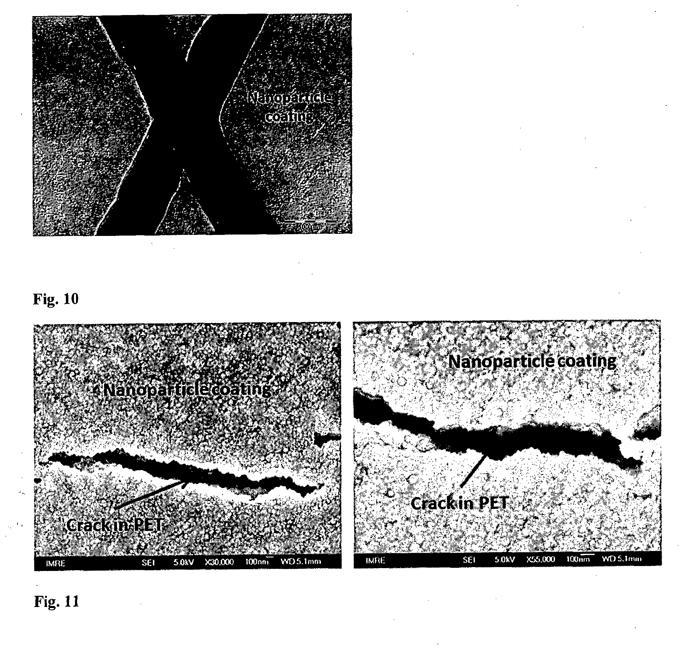

**Fig. 7** shows the tensile stress load versus axial strain curve for the nanoparticle coated PET sample that was prepared by slot die coating in a roll to roll process. The sample were subjected to 0.5, 1.0, 3.0, 5.0 and 10.0 % of axial strain and compared to a sample that not subjected to axial strain. The elastic region is considered up to 0.6 % of axial strain whereas beyond 0.6 % is considered as inelastic region. SEM images show that no cracks formation on the nanoparticles coated surface when the samples were subjected to axial strain up to 5 %. The sample subjected to 10 % axial strain shows visible cracks on the nanoparticles coated surface as shown in **Fig. 8**. As shown in **Fig. 9**, here is no change in transparency (wavelength ranging from 190 nm to 1100 nm) for samples before and after tensile except for the sample subjected to 10 % axial strain which shows a change in transparency of about 2 % The optical images taken after the X-cut peel test on the stretched samples show extremely good adhesion (5B, no peel of coating) as shown in **Fig. 10**.

SEM micrographs of **Fig. 11** show that 10 % of axial strained samples have shown cracks formation not only on the nanoparticle coated surface but also in the PET. The PET substrate manufacturer data sheet show that the force required to elongate 5 % of gauge length (the length of the sample between the two clamped ends) is 10 kgf per mm². From the experimental data, the force required to produce 5 % of strain is approximately 313 N which is closely matching the experimental result (width is 25.2 mm and the thickness is 125 microns). Since the coating thickness of the nanoparticle sealing layer is negligibly small (< 500 nm) when compared to the PET thickness, it is neglected for the sample cross sectional area calculation. From the above results it is concluded that the experimentally observed strain is mainly caused by the PET elongation. The PET deformation and crack formation causes the adhered nanoparticle coating to deform and leading to crack formation in it. These cracking may cause the drop in transparency by 2% in the visible region when the axial strain on the sample is 10 % or more as shown in **Fig. 9**. Hence by choosing the suitable substrate with desired strain properties, the stretching performance of barrier nanoparticle coating can be improved beyond 5 %.

### Embodiment 5

1. Plastic substrate - PET
2. Polymer encapsulated nanoparticle layer

Nano Solution Preparation: The solvents propylene glycol monomethyl ether acetate and cyclohexanone are mixed in the ratio of 1:1 (10ml). Thereafter, 3-methacryloxypropyltrimethoxysilane (3.5ml) and surfactant Dow Corning® 56 (a siloxane additive that is typically used to eliminate microfoam in solvent-based systems and acts as leveling agent, 0.5% by total weight of the solution) are further added and the reaction mixture is mixed. The UV curable monomer 1,6-hexanediol diacrylate (Sigma Aldrich - 8 ml) is then added to the above mixture and the resulting mixture is kept in sonication for 2 hours. The surface functionalized nanoparticle zinc oxide NanoTek® Z1102PMA (50% in 1,2-propanediol monomethyl ether acetate - 20ml) is then added to the solvent/monomer mixture and sonicated for a few hours. The above mixture is then spin-coated onto the plastic (PET substrate) and cured. The set of experiments were carried out with different mixture of nanoparticles and the nanoparticle containing reaction mixture was deposited by a slot die coating process (R2R) onto the plain polymer substrate.
The resulting barrier stack had a water vapour transmission rate (WVTR) at 60°C & 90% RH of less than 1 x 10⁻³g/m²·day
Transmit trance was less than 85% (close to PET transmit trance)
Adhesion was measured by ASTM standard 5B.
The surface roughness was 15nm RMS.

### Embodiment 6

1. Plastic substrate - PET
2. Dendrimer/polymer encapsulated nanoparticle coating

Nano Solution Preparation: Generation 5 PAMAM dendrimer with ethylenediamine core (2.3g mixed with 20ml of methanol) were obtained from Sigma Aldrich. Aluminum oxide nanoparticles (concentration of 40% by weight) in 1,2-propanediol monomethyl ether acetate were obtained from Alfa Aeser (Johnson and Mathey Company).

The solvent propylene glycol monomethylether acetate and cyclohexanone are mixed in a 1:1 ratio (10ml). Thereafter, 3-methacryloxypropyltrimethoxysilane (3.5ml) is added and then surfactant Dow corning 56 is further added by 0.5% by total weight of the solution and mixed. The UV curable acrylate monomer (addition clear wave - 8 ml) is then added to the above mixture. The resulting mixture is kept in sonication for 2 hours. PAMAM dendrimers (2.3 ml) are added to the mixture and the mixture is kept in sonication for 30min. Surface functionalized nanoparticle "Aluminum oxide, NanoDurTM X1130PMA (50% in 1,2- propanediol monomethyl ether acetate 20ml) are added to the solvent/monomer mixture and the mixture is sonicated for another 30min. The above mixture is then spincoated onto the plastic substrate and cured. The formulation was undertaken under inert gas environment.

The resulting barrier stack had a WVTR at 60°C & 90% RH of less than 1 x 10⁻³g/m²·day
Transmit trance was less than 85% (close to PET transmit trance).

Adhesion was measured by ASTM standard 5B.

The surface roughness was 15nm RMS.

## Claims

1. An encapsulation barrier stack, capable of encapsulating a moisture and/or oxygen sensitive article and comprising a film layer, wherein the film layer comprises:
- one or more nanoparticle sealing layer(s) arranged to be in contact with a surface of at least one substrate, wherein the substrate is not a barrier layer,
wherein the one or more nanoparticle sealing layer(s) comprise(s) a plurality of encapsulated nanoparticles, the nanoparticles being reactive in that they are capable of interacting with moisture and/or oxygen to retard the permeation of moisture and/or oxygen.

2. The encapsulation barrier stack of claim 1,
(a) wherein the one or more nanoparticle sealing layer(s) of the film layer at least essentially consist(s) of the encapsulated reactive nanoparticles, and/or
(b) wherein at least a portion of the plurality of encapsulated nanoparticles have an aliphatic, alicyclic, aromatic or arylaliphatic compound immobilized thereon, the aliphatic, alicyclic, aromatic or arylaliphatic compound having a polar group, preferably
wherein the polar group is selected from the group of a hydroxyl, a carboxyl, an amido, a thio, a seleno, a telluro group and combinations thereof, more preferably
wherein the encapsulation material is an organic material that includes a mercapto group, an epoxy group, an acrylic group, a methacrylate group, an allyl group, a vinyl group, a halogen and an amino group, and/or
(c) wherein the nanoparticles are at least partially encapsulated by a polymeric material (polymer encapsulated nanoparticles), or wherein the encapsulation material comprises an organo-metallic compound, an oligomer or a dendrimer, preferably
(i) wherein a pre-polymer is used for encapsulation, preferably
wherein the pre-polymer is an acrylic oligomer having a molecular weight less than about 1000 Da and a viscosity less than about 300 cPoise and/ or
(ii) wherein the encapsulation material is an organic material that includes a mercapto group, an epoxy group, an acrylic group, a methacrylate group, an allyl group, a vinyl group, a halogen and an amino group, and/ or
(d) wherein the encapsulation material is selected from the group consisting of an organic polymer, inorganic polymer, a water soluble polymer, organic solvent soluble polymer, biological polymer, synthetic polymer and oligomer, preferably
(i) wherein a pre-polymer is used for encapsulation, preferably
wherein the pre-polymer is an acrylic oligomer having a molecular weight less than about 1000 Da and a viscosity less than about 300 cPoise and/ or
(ii) wherein the encapsulation material is an organic material that includes a mercapto group, an epoxy group, an acrylic group, a methacrylate group, an allyl group, a vinyl group, a halogen and an amino group, and/ or
(e), wherein the encapsulation material is, prior to the encapsulation, cross-linked or cross-linkable, a UV curable group, electron beam curable or heat curable material, and/or
(f) wherein the nanoparticles are selected from pigment particles, quantum dots, colloidal particles, and combinations thereof, and/or
(g) being adapted to be arranged on a substrate, and/or
(h) wherein one of the one or more sealing layers conforms substantially to the shape of the defects present on the surface of the substrate, preferably
wherein at least the one of one or more sealing layers is formed by conformal deposition, and/or
(i) wherein the film further comprises at least one sealing layer that comprises a plurality of inert nanoparticles, preferably
wherein the inert nanoparticles comprise a material selected from the group consisting of clay, gold, copper, silver, platinum, silica, wollastonite, mullite, monmorillonite, silicate glass, fluorosilicate glass, fluoroborosilicate glass, aluminosilicate glass, calcium silicate glass, calcium aluminium silicate glass, calcium aluminium fluorosilicate glass, titanium carbide, zirconium carbide, zirconium nitride, silicon carbide, silicon nitride, a metal sulfide, and a mixture or combination thereof, and/or
(j) wherein the film layer comprises a single nanoparticle sealing layer, and/or
(k) wherein the nanoparticles of the nanoparticle layer are capable of interacting with moisture and/or oxygen through chemical reaction,and/or
(l) wherein the nanoparticles comprise a material selected from the group consisting of a metal, a metal oxide and a combination thereof, and/or
(m) comprising at least two nanoparticle sealing layers, wherein each of the at least two nanoparticle sealing layers comprises a different nanoparticle material.

3. The barrier stack of claims 2(l) or 2(m),
(a) wherein the nanoparticles comprise a metal selected from the group consisting of Al, Ti, Mg, Ba, Ca and alloys thereof, and/or
(b) wherein the nanoparticles comprise a metal oxide selected from the group consisting of TiO₂, Al₂O₃, ZrO₂, ZnO, BaO, SrO, CaO, MgO, VO₂, CrO₂, MoO₂, and LiMn₂O₄, and/or
(c) wherein the nanoparticles comprise a transparent conductive oxide selected from the group consisting of cadmium stannate (Cd₂SnO₄), cadmium indate (CdIn₂O₄), zinc stannate (Zn₂SnO₄ and ZnSnO₃), and zinc indium oxide (Zn₂In₂O₅), barium titanate and barium strontium titanate.

4. The barrier stack of any one of claims 1 to 3,
(a) wherein the nanoparticles are capable of interacting with moisture and/or oxygen through adsorption, preferably wherein the nanoparticles comprise carbon nanotubes, graphene nanosheets or graphene nanoflakes, and/or
(b) wherein at least one of the one or more sealing layers further comprises a plurality of inert nanoparticles, the inert nanoparticles being capable of obstructing the permeation of moisture and/or oxygen.

5. The barrier stack of claim 4(b), wherein the inert nanoparticles comprise a material selected from the group consisting of gold, copper, silver, platinum, silica, wollastonite, mullite, monmorillonite, silicate glass, fluorosilicate glass, fluoroborosilicate glass, aluminosilicate glass, calcium silicate glass, calcium aluminium silicate glass, calcium aluminium fluorosilicate glass, titanium carbide, zirconium carbide, zirconium nitride, silicon carbide, silicon nitride, a metal sulfide, and a mixture or combination thereof.

6. The barrier stack of any one of the preceding claims, further comprising a substrate supporting the film layer, preferably
wherein film layer is orientated such that the at least one nanoparticle sealing layer is arranged on the substrate.

7. The barrier stack of any of claims 5 to 6,
(a) wherein the substrate comprises an organic material or an inorganic material or a mixture thereof, preferably wherein the substrate comprises a material selected from polyacetate, polypropylene, polyimide, cellophane, poly(1-trimethylsilyl-1-propyne, poly(4-methyl-2-pentyne), polyimide, polycarbonate, polyethylene, polyethersulfone, epoxy resins, polyethylene terephthalate (PET), polystyrene, polyurethane, polyacrylate, and polydimethylphenylene oxide, styrenedivinylbenzene copolymers, polyvinylidene fluoride (PVDF), nylon, nitrocellulose, cellulose, glass, indium tin oxide, nano-clays, silicones, polydimethylsiloxanes, biscyclopentadienyl iron, and polyphosphazenes, and/or
(b)
(i) wherein the substrate is flexible, or
(ii) wherein the substrate is rigid, and/or
(c) further comprising a planarising layer, wherein the planarising layer is arranged between the substrate and the film layer.

8. The barrier stack of any one of claims 1 to 7,
(a) further comprising a terminal layer for protecting the film layer, wherein the terminal layer is facing the ambience, preferably wherein the terminal layer comprises an acrylic film or wherein the terminal layer is an oxide layer, more preferably
wherein the acrylic film has distributed therein LiF and/or MgF₂ particles, and/or
(b) wherein the encapsulation barrier stack has a water vapour transmission rate of less than about 10⁻³ g/m²/day or less than about 10⁻⁴ g/m²/day, and/or
(c) wherein the one or more sealing layers provide at least one property selected from the group of moisture and oxygen barrier properties, a UV filter property, an antireflection property, a light extraction property and an anti-static property, and/or
(d) further comprising arranged on the at least one nanoparticle sealing layer a further layer, preferably
wherein the further layer is a polymer layer containing no reactive nanoparticles or a polymer layer in which reactive nanoparticles are distributed in a polymeric matrix.

9. A food packaging material comprising an encapsulation barrier stack as defined in any of claims 1 to 8, preferably
wherein the food packaging is selected from flexible polymer films, card boards, paper, metal foil, metal foil laminated paper, metal foil laminated plastic, plastic laminated paper or plastic laminated card board.

10. An electronic module comprising an electronic device that is sensitive to moisture and/or oxygen, said electronic device being arranged within an encapsulation barrier stack according to any one of claims 1 to 8.

11. The electronic module of claim 10,
(a) wherein the electronic device is selected from the group consisting of an Organic Light Emitting Device (OLED), an Liquid Crystal Device (LCD), a quantum dot device, an Electronic E-Ink based display, an Electronic Paper, a charged-coupled device (CCD), a solar cell, a thin-film battery, an Organic Thin Film Transistor (OTFT), an organic Integrated Circuit (IC), an organic sensor, and a micro-electromechanical sensor (MEMS), and/or
(b) wherein the barrier stack defines a base substrate for supporting the electronic device, or
(c) wherein the encapsulation barrier stack further comprises a covering layer arranged proximally above the electronic device, thereby defining a proximal encapsulation, the electronic device being sandwiched between the covering layer and the encapsulation barrier stack, preferably
wherein the shape of the covering layer conforms to the external shape of the electronic device, or
(d) wherein the electronic device is arranged on a base substrate, and the encapsulation barrier stack forms an encapsulation layer over the electronic device to seal the electronic device from the environment.

12. A method of manufacturing an encapsulation barrier stack according to any one of claims 1 to 8, the method comprising:
- providing a substrate, wherein the substrate is not a barrier layer, and
- forming a film layer that comprises one or more nanoparticle sealing layer(s), wherein forming the one or more nanoparticle sealing layer(s) comprises
(i) mixing a polymerisable compound or a cross-linkable compound with a plurality of nanoparticles, the nanoparticles being reactive in that they are capable of interacting with moisture and/or oxygen, thereby forming a sealing mixture,
(ii) applying the sealing mixture onto the substrate and polymerising the polymerisable compound or to cross-link the cross-linkable compound to form a polymer under conditions allowing the nanoparticles to be encapsulated by the formed polymer.

13. The method of claim 12,
(a) further comprising adding a surfactant to the sealing mixture, and/or
(b) further comprising adding a surface modifying compound to the sealing mixture, preferably wherein the surface modifying compound is a silane, and/or
(c) wherein the conditions and/or the concentration of the polymerisable compound is chosen such that the polymerisable compound is immobilized on the surface of the reactive nanoparticles, and/or
(d) wherein the sealing mixture is applied onto the substrate via conformal deposition, preferably
wherein the sealing mixture is applied onto the barrier layer by means of spin coating, screen printing, a WebFlight method, slot die, curtain gravure, knife coating, ink jet printing, screen printing, dip coating, plasma polymerisation or a chemical vapour deposition (CVD) method, and/or
(e) wherein after being deposited onto the substrate the sealing mixture is exposed to conditions that initiate polymerization of the polymerisable compound or cross-linking the cross-linkable compound, preferably
wherein the conditions that initiate polymerization comprise UV radiation or IR radiation, electron beam curing, plasma polymerisation (for curing of the polymerisable compound or crosslinking the cross-linkable compound), and/or
(f) wherein the one or more nanoparticle sealing layer(s) formed at least essentially consist(s) of the polymer encapsulated reactive nanoparticles, and/or
(g) further comprising carrying out sonification of the sealing mixture prior to polymerization, preferably
wherein sonification is carried out for at least about 30 minutes, and/or
(h) wherein the substrate comprises an organic material or an inorganic material or a mixture thereof, preferably
wherein the substrate comprises a material selected from polyacetate, polypropylene, polyimide, cellophane, poly(1-trimethylsilyl-1-propyne, poly(4-methyl-2-pentyne), polyimide, polycarbonate, polyethylene, polyethersulfone, epoxy resins, polyethylene terephthalate (PET), polystyrene, polyurethane, polyacrylate, and polydimethylphenylene oxide, styrenedivinylbenzene copolymers, polyvinylidene fluoride (PVDF), nylon, nitrocellulose, cellulose, glass, indium tin oxide, nano-clays, silicones, polydimethylsiloxanes, biscyclopentadienyl iron, and polyphosphazenes, and/or
(i) wherein the plurality of nanoparticles is a colloidal dispersion comprising nanoparticles dispersed in an organic solvent, and/or
(j) wherein the mixing of the polymerisable compound with the plurality of nanoparticles is carried out in a polar organic solvent, preferably
wherein the polar organic solvent comprises a mixture of isopropanol and ethyl acetate in 1 : 3 molar ratio, and/or
(k) wherein the polymerisable or cross-linkable compound is curable by ultraviolet light, infrared light, electron beam curing, plasma polymerisation and or heat curing, preferably wherein the polymerisable compound is selected from acrylic acid, methyl acrylate, ethyl acrylate and butyl acrylate or wherein the cross-linkable compound is a dendrimer, an oligomer or a polymer, and/or
(l) wherein mixing of the polymerisable or cross-linkable compound with the plurality of nanoparticles in step (i) comprises mixing about 25 wt.-% dry form or less of the monomer to 100 wt.-% dry form of the nanoparticles (weight ratio 1:4), preferably wherein the polymerisable or cross-linkable compound is mixed with the nanoparticle at a weight ratio of 1: 5 or less, and/or
(m) wherein the sealing mixture obtained in step (i) comprises 10 % (w/v) or less of the polymerizable or cross-linkable compound, preferably
wherein the sealing mixture comprises about 5 % (w/v) of the polymerizable or cross-linkable compound.

14. Use of polymer or dendrimer encapsulated reactive nanoparticles for preparing a sealing layer of an encapsulation barrier stack as defined in claims 1-8, wherein the nanoparticles are reactive in that they are capable of interacting with moisture and/or oxygen to retard the permeation of moisture and/or oxygen through the defects present in the substrate.

15. Use of an encapsulation barrier stack as defined in any of claims 1-8 for use in food packaging, pharmaceutical packaging, medical packaging or encapsulation of an electronic device.

## Patentansprüche

1. Verkapselungsbarrierestack, der in der Lage ist, einen feuchtigkeits- und/oder sauerstoffempfindlichen Artikel zu verkapseln, und der eine Folienschicht umfasst, wobei die Folienschicht umfasst:
- eine oder mehrere Nanopartikel-Versiegelungsschichten, die so angeordnet sind, dass sie mit einer Oberfläche von zumindest einem Substrat in Kontakt stehen, wobei das Substrat keine Barriereschicht ist,
wobei die eine oder mehreren Nanopartikel-Versiegelungsschichten eine Vielzahl von verkapselten Nanopartikeln umfassen, wobei die Nanopartikel insofern reaktiv sind, dass sie in der Lage sind, mit Feuchtigkeit und/oder Sauerstoff zu interagieren, um die Permeation von Feuchtigkeit und/oder Sauerstoff zu verzögern.

2. Verkapselungsbarrierestack nach Anspruch 1,
(a) wobei die eine oder mehreren Nanopartikel-Versiegelungsschichten der Folienschicht zumindest im Wesentlichen aus den verkapselten reaktiven Nanopartikeln bestehen, und/oder
(b) wobei zumindest ein Teil der Vielzahl von verkapselten Nanopartikeln eine aliphatische, alicyclische, aromatische oder arylaliphatische Verbindung aufweist, die darauf immobilisiert ist, wobei die aliphatische, alicyclische, aromatische oder arylaliphatische Verbindung eine polare Gruppe aufweist, wobei vorzugsweise die polare Gruppe ausgewählt ist aus der Gruppe einer Hydroxyl-, einer Carboxyl-, einer Amido-, einer Thio-, einer Seleno-, einer Tellurogruppe und Kombinationen davon, wobei besonders bevorzugt das Verkapselungsmaterial ein organisches Material ist, das eine Mercaptogruppe, eine Epoxygruppe, eine Acrylgruppe, eine Methacrylatgruppe, eine Allylgruppe, eine Vinylgruppe, ein Halogen und eine Aminogruppe einschließt, und/oder
(c) wobei die Nanopartikel zumindest teilweise durch ein Polymermaterial verkapselt sind (polymerverkapselte Nanopartikel), oder wobei das Verkapselungsmaterial eine organometallische Verbindung, ein Oligomer oder ein Dendrimer umfasst, wobei vorzugsweise
(i) ein Präpolymer zur Verkapselung verwendet wird, wobei vorzugsweise das Präpolymer ein
Acryloligomer mit einem Molekulargewicht von weniger als etwa 1000 Da und einer Viskosität von weniger als etwa 300 cPoise ist und/oder
(ii) wobei das Verkapselungsmaterial ein organisches Material ist, das eine Mercaptogruppe, eine Epoxygruppe, eine Acrylgruppe, eine Methacrylatgruppe, eine Allylgruppe, eine Vinylgruppe, ein Halogen und eine Aminogruppe einschließt, und/oder
(d) wobei das Verkapselungsmaterial ausgewählt ist aus der Gruppe bestehend aus einem organischen Polymer, einem anorganischen Polymer, einem wasserlöslichen Polymer, einem in organischen Lösungsmitteln löslichen Polymer, einem biologischen Polymer, einem synthetischen Polymer und einem Oligomer, wobei vorzugsweise
(i) ein Präpolymer zur Verkapselung verwendet wird, wobei vorzugsweise das Präpolymer ein Acryloligomer mit einem Molekulargewicht von weniger als etwa 1000 Da und einer Viskosität von weniger als etwa 300 cPoise ist und/oder
(ii) wobei das Verkapselungsmaterial ein organisches Material ist, das eine Mercaptogruppe, eine Epoxygruppe, eine Acrylgruppe, eine Methacrylatgruppe, eine Allylgruppe, eine Vinylgruppe, ein Halogen und eine Aminogruppe einschließt, und/oder
(e) wobei das Verkapselungsmaterial vor der Verkapselung vernetzt oder vernetzbar ist, eine UV-härtbare Gruppe, ein durch Elektronenstrahlen härtbares oder durch Wärme härtbares Material ist, und/oder
(f) wobei die Nanopartikel ausgewählt sind aus Pigmentpartikeln, Quantenpunkten, kolloidalen Partikeln und Kombinationen davon, und/oder
(g) wobei er angepasst ist, um auf einem Substrat angeordnet zu werden, und/oder
(h) wobei eine der einen oder mehreren Versiegelungsschichten im Wesentlichen der Form der auf der Oberfläche des Substrats vorhandenen Defekte entspricht, wobei vorzugsweise zumindest eine der einen oder mehreren Versiegelungsschichten durch konforme Abscheidung gebildet wird, und/oder
(i) wobei die Folie ferner zumindest eine Versiegelungsschicht umfasst, die eine Vielzahl inerter Nanopartikel umfasst, wobei vorzugsweise die inerten Nanopartikel ein Material umfassen, das ausgewählt ist aus der Gruppe bestehend aus Ton, Gold, Kupfer, Silber, Platin, Silica, Wollastonit, Mullit, Monmorillonit, Silicatglas, Fluorsilicatglas, Fluorborsilicatglas, Aluminosilicatglas, Calciumsilicatglas, Calciumaluminiumsilicatglas, Calciumaluminiumfluorsilicatglas, Titancarbid, Zirkoniumcarbid, Zirkoniumnitrid, Siliciumcarbid, Siliciumnitrid, einem Metallsulfid und einer Mischung oder Kombination davon, und/oder
(j) wobei die Folienschicht eine einzelne Nanopartikel-Versiegelungsschicht umfasst, und/oder
(k) wobei die Nanopartikel der Nanopartikelschicht in der Lage sind, mit Feuchtigkeit und/oder Sauerstoff durch chemische Reaktion zu interagieren, und/oder
(l) wobei die Nanopartikel ein Material umfassen, das ausgewählt ist aus der Gruppe bestehend aus einem Metall, einem Metalloxid und einer Kombination davon, und/oder
(m) umfassend zumindest zwei Nanopartikel-Versiegelungsschichten, wobei jede der zumindest zwei Nanopartikel-Versiegelungsschichten ein unterschiedliches Nanopartikel-Material umfasst.

3. Barrierestack nach Anspruch 2(l) oder 2(m),
(a) wobei die Nanopartikel eine Metall umfassen, ausgewählt aus der Gruppe bestehend aus Al, Ti, Mg, Ba, Ca und Legierungen davon, und/oder
(b) wobei die Nanopartikel ein Metalloxid umfassen, ausgewählt aus der Gruppe bestehend aus TiO₂, Al₂O₃, ZrO₂, ZnO, BaO, SrO, CaO, MgO, VO₂, CrO₂, MoO₂ und LiMn₂O₄, und/oder
(c) wobei die Nanopartikel ein transparentes leitfähiges Oxid umfassen, ausgewählt aus der Gruppe bestehend aus Cadmiumstannat (Cd₂SnO₄), Cadmiumindat (CdIn₂O₄), Zinkstannat (Zn₂SnO₄ und ZnSnO₃) und Zinkindiumoxid (Zn₂In₂O₅), Bariumtitanat und Bariumstrontiumtitanat.

4. Barrierestack nach einem der Ansprüche 1 bis 3,
(a) wobei die Nanopartikel in der Lage sind, mit Feuchtigkeit und/oder Sauerstoff durch Adsorption zu interagieren, wobei vorzugsweise die Nanopartikel Kohlenstoffnanoröhren, Graphennanoblätter oder Graphennanoflocken umfassen, und/oder
(b) wobei zumindest eine der einen oder mehreren Versiegelungsschichten ferner eine Vielzahl inerter Nanopartikel umfasst, wobei die inerten Nanopartikel in der Lage sind, die Permeation von Feuchtigkeit und/oder Sauerstoff zu behindern.

5. Barrierestack nach Anspruch 4(b), wobei die inerten Nanopartikel ein Material umfassen, ausgewählt aus der Gruppe bestehend aus Gold, Kupfer, Silber, Platin, Silica, Wollastonit, Mullit, Monmorillonit, Silicatglas, Fluorsilicatglas, Fluorborsilicatglas, Aluminosilicatglas, Calciumsilicatglas, Calciumaluminiumsilicatglas, Calciumaluminiumfluorsilicatglas, Titancarbid, Zirkoniumcarbid, Zirkoniumnitrid, Siliciumcarbid, Siliciumnitrid, einem Metallsulfid und einer Mischung oder Kombination davon.

6. Barrierestack nach einem der voranghenden Ansprüche, der ferner ein Substrat umfasst, welches die Folienschicht trägt, wobei vorzugsweise die Folienschicht derart orientiert ist, dass die zumindest eine Nanopartikel-Versiegelungsschicht auf dem Substrat angeordnet ist.

7. Barrierestack nach einem der Ansprüche 5 bis 6,
(a) wobei das Substrat ein organisches Material oder ein anorganisches Material oder eine Mischung davon umfasst, wobei vorzugsweise das Substrat ein Material umfasst, ausgewählt aus Polyacetat, Polypropylen, Polyimid, Cellophan, Poly(1-trimethylsilyl-1-propin), Poly(4-methyl-2-pentin), Polyimid, Polycarbonat, Polyethylen, Polyethersulfon, Epoxyharzen, Polyethylenterephthalat (PET), Polystyrol, Polyurethan, Polyacrylat und Polydimethylphenylenoxid, Styrol-Divinylbenzol-Copolymeren, Polyvinylidenfluorid (PVDF), Nylon, Nitrocellulose, Cellulose, Glas, Indiumzinnoxid, Nano-Tonen, Siliconen, Polydimethylsiloxanen, Biscyclopentadienyleisen und Polyphosphazenen, und/oder
(b)
(i) wobei das Substrat flexibel ist, oder
(ii) wobei das Substrat starr ist, und/oder
(c) ferner umfassend eine Planarisierungsschicht, wobei die Planarisierungsschicht zwischen dem Substrat und der Folienschicht angeordnet ist.

8. Barrierestack nach einem der Ansprüche 1 bis 7,
(a) ferner umfassend eine Endschicht zum Schützen der Folienschicht, wobei die Endschicht der Umgebung zugewandt ist, wobei vorzugsweise die Endschicht eine Acrylfolie umfasst oder wobei die Endschicht eine Oxidschicht ist, wobei stärker bevorzugt die Acrylfolie darin verteilte LiF- und/oder MgF₂-Partikel aufweist, und/oder
(b) wobei der Verkapselungsbarrierestack eine Wasserdampfdurchlässigkeitsrate von weniger als ungefähr 10⁻³ g/m²/Tag oder weniger als ungefähr 10⁻⁴ g/m²/Tag aufweist, und/oder
(c) wobei die eine oder mehreren Versiegelungsschichten mindestens eine Eigenschaft bereitstellen, die aus der Gruppe von Feuchtigkeits- und Sauerstoffbarriereeigenschaften, einer UV-Filtereigenschaft, einer Antireflexionseigenschaft, einer Lichtextraktionseigenschaft und einer antistatischen Eigenschaft ausgewählt ist, und/oder
(d) ferner umfassend eine weitere Schicht, die auf der zumindest einen Nanopartikel-Versiegelungsschicht angeordnet ist, wobei vorzugsweise die weitere Schicht eine Polymerschicht, die keine reaktiven Nanopartikel enthält, oder eine Polymerschicht, in der reaktive Nanopartikel in einer Polymermatrix verteilt sind, ist.

9. Lebensmittelverpackungsmaterial, umfassend einen Verkapselungsbarrierestack, wie in einem der Ansprüche 1 bis 8 definiert, wobei vorzugsweise die Lebensmittelverpackung ausgewählt ist aus flexiblen Polymerfolien, Karton, Papier, Metallfolie, Metallfolien-Laminatpapier, Metallfolien-Laminatkunststoff, Kunststoff-Laminatpapier oder Kunststoff-Laminatkarton.

10. Elektronisches Modul, umfassend eine elektronische Vorrichtung, die gegenüber Feuchtigkeit und/oder Sauerstoff empfindlich ist, wobei die elektronische Vorrichtung in einem Verkapselungsbarrierestack nach einem der Ansprüche 1 bis 8 angeordnet ist.

11. Elektronisches Modul nach Anspruch 10,
(a) wobei die elektronische Vorrichtung ausgewählt ist aus der Gruppe bestehend aus einer organischen lichtemittierenden Vorrichtung (OLED), einer Flüssigkristallvorrichtung (LCD), einer Quantenpunktvorrichtung, einer elektronischen Anzeige auf E-Ink-Basis, einem elektronischen Papier, einer ladungsgekoppelten Vorrichtung (CCD), einer Solarzelle, einer Dünnschichtbatterie, einem organischen Dünnschichttransistor (OTFT), einer organischen integrierten Schaltung (IC), einem organischen Sensor und einem mikroelektromechanischen Sensor (MEMS), und/oder
(b) wobei der Barrierestack ein Basissubstrat zum Tragen der elektronischen Vorrichtung definiert, oder
(c) wobei der Verkapselungsbarrierestack ferner eine Deckschicht umfasst, die proximal über der elektronischen Vorrichtung angeordnet ist, wodurch eine proximale Verkapselung definiert wird, wobei die elektronische Vorrichtung zwischen der Deckschicht und dem Verkapselungsbarrierestack angeordnet ist, wobei vorzugsweise die Form der Deckschicht der äußeren Form der elektronischen Vorrichtung entspricht, oder
(d) wobei die elektronische Vorrichtung auf einem Basissubstrat angeordnet ist und der Verkapselungsbarrierestack eine Verkapselungsschicht über der elektronischen Vorrichtung bildet, um die elektronische Vorrichtung vor der Umgebung zu versiegeln.

12. Verfahren zur Herstellung eines Verkapselungsbarrierestacks nach einem der Ansprüche 1 bis 8, wobei das Verfahren umfasst:
- Bereitstellen eines Substrats, wobei das Substrat keine Barriereschicht ist, und
- Bilden einer Folienschicht, die eine oder mehrere Nanopartikel-Versiegelungsschichten umfasst, wobei das Bilden der einen oder mehreren Nanopartikel-Versiegelungsschichten umfasst
(i) Mischen einer polymerisierbaren Verbindung oder einer vernetzbaren Verbindung mit einer Vielzahl von Nanopartikeln, wobei die Nanopartikel insofern reaktiv sind, dass sie in der Lage sind, mit Feuchtigkeit und/oder Sauerstoff zu interagieren, wodurch eine Versiegelungsmischung gebildet wird,
(ii) Aufbringen der Versiegelungsmischung auf das Substrat und Polymerisieren der polymerisierbaren Verbindung oder Vernetzen der vernetzbaren Verbindung zur Bildung eines Polymers unter Bedingungen, die es ermöglichen, dass die Nanopartikel von dem gebildeten Polymer verkapselt werden.

13. Verfahren nach Anspruch 12,
(a) ferner umfassend Zugeben eines Tensids zu der Versiegelungsmischung, und/oder
(b) ferner umfassend Zugeben einer oberflächenmodifizierenden Verbindung zu der Versiegelungsmischung, wobei vorzugsweise die oberflächenmodifizierende Verbindung ein Silan ist, und/oder
(c) wobei die Bedingungen und/oder die Konzentration der polymerisierbaren Verbindung so gewählt werden, dass die polymerisierbare Verbindung auf der Oberfläche der reaktiven Nanopartikel immobilisiert wird, und/oder
(d) wobei die Versiegelungsmischung durch konforme Abscheidung auf das Substrat aufgebracht wird, wobei vorzugsweise die Versiegelungsmischung auf die Barriereschicht mittels Spin-Coating, Siebdruck, einem WebFlight-Verfahren, Schlitzdüse, Vorhang-Tiefdruck, Rakelbeschichtung, Tintenstrahldruck, Siebdruck, Tauchbeschichtung, Plasmapolymerisation oder einem chemischen Dampfabscheideverfahren (CVD) aufgebracht wird, und/oder
(e) wobei die Versiegelungsmischung nach dem Aufbringen auf das Substrat Bedingungen ausgesetzt wird, die eine Polymerisation der polymerisierbaren Verbindung oder eine Vernetzung der vernetzbare Verbindung initiieren, wobei vorzugsweise die Bedingungen, die die Polymerisation initiieren, UV-Strahlung oder IR-Strahlung, Elektronenstrahlhärtung, Plasmapolymerisation (zum Härten der polymerisierbaren Verbindung oder Vernetzen der vernetzbaren Verbindung) umfassen, und/oder
(f) wobei die eine oder mehreren gebildeten Nanopartikel-Versiegelungsschichten zumindest im Wesentlichen aus den polymerverkapselten reaktiven Nanopartikeln bestehen, und/oder
(g) ferner umfassend Durchführen einer Sonifikation der der Versiegelungsmischung vor der Polymerisation, wobei vorzugsweise die Sonifikation für mindestens etwa 30 Minuten durchgeführt wird, und/oder
(h) wobei das Substrat ein organisches Material oder ein anorganisches Material oder eine Mischung davon umfasst,
wobei vorzugsweise das Substrat ein Material umfasst, ausgewählt aus Polyacetat, Polypropylen, Polyimid, Cellophan, Poly(1-trimethylsilyl-1-propin), Poly(4-methyl-2-pentin), Polyimid, Polycarbonat, Polyethylen, Polyethersulfon, Epoxyharzen, Polyethylenterephthalat (PET), Polystyrol, Polyurethan, Polyacrylat und Polydimethylphenylenoxid, Styrol-Divinylbenzol-Copolymeren, Polyvinylidenfluorid (PVDF), Nylon, Nitrocellulose, Cellulose, Glas, Indiumzinnoxid, Nano-Tonen, Siliconen, Polydimethylsiloxanen, Biscyclopentadienyleisen und Polyphosphazenen, und/oder
(i) wobei die Vielzahl von Nanopartikeln eine kolloidale Dispersion ist, die in einem organischen Lösungsmittel dispergierte Nanopartikel umfasst, und/oder
(j) wobei das Mischen der polymerisierbaren Verbindung mit der Vielzahl von Nanopartikeln in einem polaren organischen Lösungsmittel durchgeführt wird, wobei vorzugsweise das polare organische Lösungsmittel eine Mischung aus Isopropanol und Ethylacetat im Molverhältnis 1:3 umfasst und/oder
(k) wobei die polymerisierbare oder vernetzbare Verbindung durch Ultraviolettlicht, Infrarotlicht, Elektronenstrahlhärten, Plasmapolymerisation und/oder Wärmehärten härtbar ist, wobei vorzugsweise die polymerisierbare Verbindung ausgewählt ist aus Acrylsäure, Methylacrylat, Ethylacrylat und Butylacrylat oder wobei die vernetzbare Verbindung ein Dendrimer, ein Oligomer oder ein Polymer ist, und/oder
(l) wobei das Mischen der polymerisierbaren oder vernetzbaren Verbindung mit der Vielzahl von Nanopartikeln in Schritt (i) das Mischen von etwa 25 Gew.-% in Trockenform oder weniger des Monomers zu 100 Gew.-% in Trockenform der Nanopartikel (Gewichtsverhältnis 1:4) umfasst, wobei vorzugsweise die polymerisierbare oder vernetzbare Verbindung mit dem Nanopartikel in einem Gewichtsverhältnis von 1:5 oder weniger gemischt wird, und/oder
(m) wobei die in Schritt (i) erhaltene Versiegelungsmischung 10% (w/v) oder weniger der polymerisierbaren oder vernetzbaren Verbindung umfasst, wobei vorzugsweise die Versiegelungsmischung etwa 5% (w/v) der polymerisierbaren oder vernetzbaren Verbindung umfasst.

14. Verwendung von Polymer- oder Dendrimer-verkapselten reaktiven Nanopartikeln zur Herstellung einer Versiegelungsschicht eines Verkapselungsbarrierestacks, wie in den Ansprüchen 1 bis 8 definiert, wobei die Nanopartikel insofern reaktiv sind, dass sie in der Lage sind, mit Feuchtigkeit und/oder Sauerstoff zu interagieren, um die Permeation von Feuchtigkeit und/oder Sauerstoff durch die im Substrat vorhandenen Defekte zu verzögern.

15. Verwendung eines Verkapselungsbarrierestacks, wie in einem der Ansprüche 1 bis 8 definiert, zur Verwendung in Lebensmittelverpackungen, pharmazeutischen Verpackungen, medizinischen Verpackungen oder zur Verkapselung einer elektronischen Vorrichtung.

## Revendications

1. Empilement de barrières d'encapsulation, capable d'encapsuler un article sensible à l'humidité et/ou à l'oxygène et comprenant une couche de film, dans lequel la couche de film comprend:
une ou plusieurs couche(s) d'étanchéité à nanoparticules agencée(s) pour être en contact avec une surface d'au moins un substrat, dans laquelle le substrat n'est pas une couche barrière,
dans laquelle la ou les couche(s) d'étanchéité à nanoparticules comprennent une ou plusieurs nanoparticules encapsulées, les nanoparticules étant réactives en ce qu'elles sont capables d'interagir avec l'humidité et/ou l'oxygène pour retarder la perméation d'humidité et/ou d'oxygène.

2. Empilement de barrières d'encapsulation selon la revendication 1,
(a) dans lequel la ou les couche(s) d'étanchéité à nanoparticules de la couche de film sont au moins essentiellement constituées des nanoparticules réactives encapsulées, et/ou
(b) dans laquelle au moins une partie de la pluralité de nanoparticules encapsulées présente un composé aliphatique, alicyclique, aromatique ou arylaliphatique immobilisé sur elles, le composé aliphatique, alicyclique, aromatique ou arylaliphatique ayant un groupe polaire, de préférence
dans laquelle le groupe polaire est choisi dans le groupe constitué par un groupe hydroxyle, un groupe carboxyle, un groupe amido, un groupe thio, un groupe séléno, un groupe telluro et leurs combinaisons, de préférence
dans laquelle le matériau d'encapsulation est une matière organique qui comprend un groupe mercapto, un groupe époxy, un groupe acrylique, un groupe méthacrylate, un groupe allyle, un groupe vinyle, un halogène et un groupe amino, et/ou
(c) dans laquelle les nanoparticules sont au moins partiellement encapsulées par un matériau polymère (nanoparticules encapsulées dans un polymère), ou dans lequel le matériau d'encapsulation comprend un composé organo-métallique, un oligomère ou un dendrimère, de préférence
(i) dans lequel un prépolymère est utilisé pour l'encapsulation, de préférence dans laquelle le prépolymère est un oligomère acrylique ayant un poids moléculaire inférieur à environ 1000 Da et une viscosité inférieure à environ 300 cPoise et/ou
(ii) dans laquelle le matériau d'encapsulation est une matière organique qui comprend un groupe mercapto, un groupe époxy, un groupe acrylique, un groupe méthacrylate, un groupe allyle, un groupe vinyle, un halogène et un groupe amino, et/ou
(d) dans laquelle le matériau d'encapsulation est choisi dans le groupe constitué par un polymère organique, un polymère inorganique, un polymère soluble dans l'eau, un polymère soluble dans un solvant organique, un polymère soluble dans un solvant organique, un polymère biologique, un polymère synthétique et un oligomère synthétique, de préférence
(i) dans lequel un prépolymère est utilisé pour l'encapsulation, de préférence dans laquelle le prépolymère est un oligomère acrylique ayant un poids moléculaire inférieur à environ 1000 Da et une viscosité inférieure à environ 300 cPoise et/ou
(ii) dans laquelle le matériau d'encapsulation est une matière organique qui comprend un groupe mercapto, un groupe époxy, un groupe acrylique, un groupe méthacrylate, un groupe allyle, un groupe vinyle, un halogène et un groupe amino, et/ou
(e), dans lequel le matériau d'encapsulation est, avant l'encapsulation, réticulé ou réticulable, un groupe durcissable par UV, un matériau durcissable par faisceau d'électrons ou par la chaleur, et/ou
(f) dans laquelle les nanoparticules sont choisies parmi les particules de pigment, les points quantiques, les particules colloïdales et leurs combinaisons, et/ou
(g) prévus pour être disposés sur un substrat, et/ou
(h) dans laquelle l'une des une ou plusieurs couches d'étanchéité se conforme sensiblement à la forme des défauts présents sur la surface du substrat, de préférence
dans laquelle au moins l'une d'une ou plusieurs couches d'étanchéité est formée par dépôt conforme,
et/ou
(i) dans laquelle le film comprend en outre au moins une couche d'étanchéité qui comprend une pluralité de nanoparticules inertes, de préférence
dans laquelle les nanoparticules inertes comprennent un matériau choisi dans le groupe constitué par l'argile, l'or, le cuivre, l'argent, le platine, la silice, la wollastonite, la mullite, la monmorillonite, le verre silicate, le verre fluorosilicate, le verre fluoroborosilicate, le verre aluminosilicate, le verre silicate de calcium, le verre silicate d'aluminium-calcium, le verre fluorosilicate d'aluminium-calcium, le verre fluorosilicate d'aluminium-calcium, le carbure de titane, le carbure de zirconium, le nitrure de zirconium, le carbure de silicium, le nitrure de silicium, un sulfure métallique et leur mélange ou combinaisons de ceux-ci, et/ou
(j) dans laquelle la couche de film comprend une seule couche d'étanchéité de nanoparticules, et/ou
(k) dans laquelle les nanoparticules de la couche de nanoparticules sont capables d'interagir avec l'humidité et/ou l'oxygène par réaction chimique, et/ou
(l) dans lequel les nanoparticules comprennent un matériau choisi dans le groupe consistant en un métal, un oxyde de métal et une combinaison de ceux-ci, et/ou
(m) comprenant au moins deux couches d'étanchéité de nanoparticules, dans lequel chacune desdites au moins deux couches d'étanchéité de nanoparticules comprend un matériau de nanoparticules différent.

3. Empilement de barrières selon les revendications 2(1) ou 2(m),
(a) dans lequel les nanoparticules comprennent un métal choisi dans le groupe constitué par Al, Ti, Mg, Ba, Ca et leurs alliages, et/ou
(b)dans laquelle les nanoparticules comprennent un oxyde métallique choisi dans le groupe constitué par TiO₂, Al₂O₃, ZrO₂, ZnO, BaO, SrO, CaO, MgO, VO₂, CrO₂, MoO₂ et LiMn₂O₄, et/ou
(c) dans laquelle les nanoparticules comprennent un oxyde conducteur transparent choisi dans le groupe constitué par le stannate de cadmium (Cd₂SnO₄), l'indate de cadmium (CdIn₂O₄), le stannate de zinc (Zn₂SnO₄ et ZnSnO₃) et l'oxyde de zinc indium (Zn₂In₂O₅), le titanate de baryum et le titanate de strontium de baryum.

4. Empilement de barrières selon l'une quelconque des revendications 1 à 3,
(a) dans lequel les nanoparticules sont capables d'interagir avec l'humidité et/ou l'oxygène par adsorption, de préférence
dans laquelle les nanoparticules comprennent des nanotubes de carbone, des nanofeuilles de graphène ou des nanoflocons de graphène, et/ou
(b) dans laquelle au moins l'une des une ou plusieurs couches d'étanchéité comprend en outre une pluralité de nanoparticules inertes, les nanoparticules inertes étant capables d'obstruer la perméation d'humidité et/ou d'oxygène.

5. Empilement de barrières selon la revendication 4(b), dans laquelle les nanoparticules inertes comprennent un matériau choisi dans le groupe constitué par l'argile, l'or, le cuivre, l'argent, le platine, la silice, la wollastonite, la mullite, la monmorillonite, le verre silicate, le verre fluorosilicate, le verre fluoroborosilicate, le verre aluminosilicate, le verre silicate de calcium, le verre silicate d'aluminium-calcium, le verre fluorosilicate d'aluminium-calcium, le verre fluorosilicate d'aluminium-calcium, le carbure de titane, le carbure de zirconium, le nitrure de zirconium, le carbure de silicium, le nitrure de silicium, un sulfure métallique et leur mélange ou combinaisons de ceux-ci.

6. Empilage de barrières de l'une quelconque des revendications précédentes, comprenant en outre un substrat supportant la couche de film, de préférence dans laquelle la couche de film est orientée de telle sorte que ladite au moins une couche d'étanchéité de nanoparticules est disposée sur le substrat.

7. Empilement de barrières selon l'une quelconque des revendications 5 à 6,
(a) dans lequel le substrat comprend une matière organique ou une matière inorganique ou un mélange de celles-ci, de préférence
dans laquelle le substrat comprend un matériau choisi parmi le polyacétate, le polypropylène, le polyimide, le cellophane, le poly(1-triméthylsilyl-1-propyne, le poly(4-méthyl-2-pentyne), le polyimide, le polycarbonate, le polyéthylène, la polyéthersulfone, les résines époxy, le polyéthylène téréphthalate (PET), le polystyrène, le polyuréthane, le polyacrylate et l'oxyde de polydiméthylphénylène, les copolymères styrène-divinylbenzène, le fluorure de polyvinylidène (PVDF), le nylon, la nitrocellulose, la cellulose, le verre, l'oxyde d'indium-étain, la nano-argile, les silicones, les polydiméthylsiloxanes, le fer de biscyclopentadiényle et les polyphosphazènes, et/ou
(b)(i) où le substrat est flexible, ou (ii)
où le substrat est rigide, et/ou
(c) comprenant en outre une couche de planarisation, dans laquelle la couche de planarisation est disposée entre le substrat et la couche de film.

8. Empilement de barrières selon l'une quelconque des revendications 1 à 7, comprenant en outre une couche terminale pour protéger la couche de film, dans lequel la couche terminale fait face à l'atmosphère environnante, de préférence dans laquelle la couche terminale comprend un film acrylique ou dans laquelle la couche terminale est une couche d'oxyde, plus préférentiellement
dans laquelle le film acrylique contient des particules de LiF et/ou MgF₂, et/ou
(b)dans laquelle la pile de barrières d'encapsulation a un taux de transmission de vapeur d'eau inférieur à environ 10⁻³ g/m²/jour ou inférieur à environ 10⁻⁴ g/m²/jour, et/ou
(c) dans laquelle la ou les couches d'étanchéité présentent au moins une propriété choisie dans le groupe des propriétés de barrière à l'humidité et à l'oxygène, une propriété de filtre UV, une propriété antireflet, une propriété d'extraction lumineuse et une propriété antistatique, et/ou
(d) comprenant en outre une couche supplémentaire, disposée sur la couche d'étanchéité d'au moins une nanoparticule, de préférence
dans laquelle la couche supplémentaire est une couche polymère ne contenant pas de nanoparticules réactives ou une couche polymère dans laquelle des nanoparticules réactives sont réparties dans une matrice polymère.

9. Matériau d'emballage alimentaire comprenant un empilement de barrières d'encapsulation tel que défini dans l'une quelconque des revendications 1 à 8, de préférence
dans laquelle l'emballage alimentaire est choisi parmi les films polymères souples, les cartons en carton, le papier, la feuille métallique, le papier laminé de feuille métallique, le plastique laminé de feuille métallique, le papier laminé de plastique ou le carton plastifié de plastique.

10. Module électronique comprenant un dispositif électronique sensible à l'humidité et/ou à l'oxygène, ledit dispositif électronique étant disposé dans un empilement de barrières d'encapsulation selon l'une quelconque des revendications 1 à 8.

11. Module électronique selon la revendication 10,
(a) dans lequel le dispositif électronique est choisi dans le groupe constitué d'un dispositif organique émetteur de lumière (OLED), d'un dispositif à cristaux liquides (LCD), d'un dispositif à points quantiques, d'un affichage électronique à encre électronique, d'un papier électronique, d'un dispositif à couplage de charge (CCD), d'une cellule solaire, d'une batterie à couche mince, d'un transistor organique en couche mince (OTFT), d'un circuit intégré organique (IC), d'un détecteur organique, et d'un micro capteur électromécanique (MEMS), et/ou
(b)dans laquelle l'empilement de barrières définit un substrat de base pour supporter le dispositif électronique, ou
(c) dans lequel l'empilement de barrières d'encapsulation comprend en outre une couche de recouvrement disposée à proximité au-dessus du dispositif électronique, définissant ainsi une encapsulation proximale, le dispositif électronique étant pris en sandwich entre la couche de recouvrement et l'empilement de barrières d'encapsulation, de préférence
dans laquelle la forme de la couche de recouvrement épouse la forme extérieure du dispositif électronique, ou
(d)dans lequel le dispositif électronique est disposé sur un substrat de base, et l'empilement de barrières d'encapsulation forme une couche d'encapsulation sur le dispositif électronique pour rendre le dispositif électronique étanche à l'environnement.

12. Procédé de fabrication d'un empilement de barrières d'encapsulation selon l'une quelconque des revendications 1 à 8, le procédé comprenant les opérations suivantes:
fournir un substrat, dans lequel le substrat n'est pas une couche barrière, et former une couche de film qui comprend une ou plusieurs couches d'étanchéité de nanoparticules, dans lequel former la ou les couches d'étanchéité de nanoparticules, dans lequel former la ou les couches d'étanchéité de nanoparticules consiste à
(i) mélanger un composé polymérisable ou un composé réticulé avec une pluralité de nanoparticules, les nanoparticules étant réactives dans la mesure où elles sont capables de coopérer avec l'humidité et/ou l'oxygène, formant ainsi un mélange étanche,
(ii) appliquer le mélange d'étanchéité sur la couche barrière et polymériser le composé polymérisable ou réticuler le composé réticulable pour former un polymère dans des conditions permettant aux nanoparticules d'être encapsulées par le polymère formé.

13. Procédé selon la revendication 12,
(a) comprenant en outre l'addition d'un agent tensioactif au mélange d'étanchéité, et/ou
(b) comprenant en outre l'addition d'un composé modifiant la surface au mélange d'étanchéité, de préférence dans lequel le composé modifiant la surface est un silane, et/ou
(c) dans laquelle les conditions et/ou la concentration du composé polymérisable sont choisies de telle sorte que le composé polymérisable est immobilisé sur la surface des nanoparticules réactives, et/ou
(d) dans lequel le mélange d'étanchéité est appliqué sur le substrat par dépôt conforme, de préférence
dans laquelle le mélange d'étanchéité est appliqué sur la couche barrière au moyen d'un revêtement par centrifugation, d'une sérigraphie, d'un procédé WebFlight, d'une matrice à fente, d'une gravure au rideau, d'un revêtement par couteau, d'une impression par jet d'encre, d'une sérigraphie, d'un revêtement par immersion, d'une polymérisation par plasma ou d'un procédé par dépôt chimique en phase vapeur (CVD), et/ou
(e)dans laquelle, après avoir été déposé sur le substrat, le mélange d'étanchéité est exposé à des conditions qui déclenchent la polymérisation du composé polymérisable ou la réticulation du composé réticulable, de préférence dans laquelle les conditions qui déclenchent la polymérisation comprennent le rayonnement UV ou le rayonnement IR, le durcissement par faisceau d'électrons, la polymérisation par plasma (pour le durcissement du composé polymérisable ou la réticulation du composé réticulable), et/ou
(f) dans lequel la ou les couche(s) d'étanchéité à nanoparticules de la couche de film sont au moins essentiellement constituées des nanoparticules réactives encapsulées, et/ou
(g) comprenant en outre la réalisation d'une sonification du mélange d'étanchéité avant la polymérisation, de préférence
dans laquelle la sonification est effectuée pendant au moins environ 30 minutes, et/ou
(h) dans lequel le substrat comprend une matière organique ou une matière inorganique ou un mélange de celles-ci, de préférence
dans laquelle le substrat comprend un matériau choisi parmi le polyacétate, le polypropylène, le polyimide, le cellophane, le poly(1-triméthylsilyl-1-propyne, le poly(4-méthyl-2-pentyne), le polyimide, le polycarbonate, le polyéthylène, la polyéthersulfone, les résines époxy, le polyéthylène téréphthalate (PET), le polystyrène, le polyuréthane, le polyacrylate et l'oxyde de polydiméthylphénylène, les copolymères styrène-divinylbenzène, le fluorure de polyvinylidène (PVDF), le nylon, la nitrocellulose, la cellulose, le verre, l'oxyde d'indium-étain, la nano-argile, les silicones, les polydiméthylsiloxanes, le fer de biscyclopentadiényle et les polyphosphazènes, et/ou
(i) dans laquelle la pluralité de nanoparticules est une dispersion colloïdale comprenant des nanoparticules dispersées dans un solvant organique, et/ou
(j) dans lequel le mélange du composé polymérisable avec la pluralité de nanoparticules est effectué dans un solvant organique polaire, de préférence
dans laquelle le solvant organique polaire comprend un mélange d'isopropanol et d'acétate d'éthyle dans un rapport molaire 1:3, et/ou
(k) dans lequel le composé polymérisable ou réticulable peut être durci par la lumière ultraviolette, la lumière infrarouge, le durcissement par faisceau d'électrons, la polymérisation par plasma et/ou le durcissement à chaud, de préférence dans laquelle le composé polymérisable est choisi parmi l'acide acrylique, l'acrylate de méthyle, l'acrylate d'éthyle et l'acrylate de butyle ou dans laquelle le composé réticulable est un dendrimère, un oligomère ou un polymère, et/ou
(l) dans lequel le mélange du composé polymérisable ou réticulable avec la pluralité de nanoparticules dans l'étape (i) comprend le mélange d'environ 25 % en poids de forme sèche ou moins du monomère à 100 % en poids de forme sèche des nanoparticules (rapport pondéral 1:4), de préférence dans lequel le composé polymérisable ou réticulable est mélangé avec la nanoparticule à raison de 1:5 ou moins, et/ou
(m) dans lequel le mélange d'étanchéité obtenu à l'étape (i) comprend 10 % (p/v) ou moins du composé polymérisable ou réticulable, de préférence dans lequel le mélange d'étanchéité comprend environ 5 % (p/v) du composé polymérisable ou réticulable.

14. Utilisation de nanoparticules réactives encapsulées dans un polymère ou un dendrimère pour préparer une couche d'étanchéité d'un empilement de barrières d'encapsulation tel que défini dans les revendications 1-8, dans laquelle les nanoparticules sont réactives en ce qu'elles sont capables d'interagir avec l'humidité et/ou l'oxygène pour retarder la pénétration d'humidité et/ou d'oxygène par les défauts présents sur le substrat.

15. Utilisation d'un empilement de barrières d'encapsulation tel que défini dans l'une quelconque des revendications 1 à 8 pour une utilisation dans un emballage alimentaire, un emballage pharmaceutique, un emballage médical ou l'encapsulation d'un dispositif électronique.
